# EUROPEAN PATENT SPECIFICATION

(11) **EP 0 914 494 B1**
(45) Date of publication and mention of the grant of the patent: **03.11.2004**
(21) Application number: 97932677.4
(22) Date of filing: 23.07.1997
(51) Int. Cl.: C23C 14/22

(54) **CAPPED POROUS THIN FILMS**
MIT DEXCKSCHICHT VERSEHENE DÜNNSCHICHTEN
FILMS MINCES POREUX RECOUVERTS

(30) Priority: 23.07.1996 US 681434; 31.07.1996 CA 2182452
(43) Date of publication of application: 12.05.1999
(73) Proprietor: THE GOVERNORS OF THE UNIVERSITY OF ALBERTA, Edmonton, Alberta T6G 2E1 (CA); Micralyne Inc., Edmonton, Alberta T5J 4K1 (CA)
(72) Inventor: ROBBIE, Kevin, John, Edmonton, Alberta T6G 2R4 (CA); BRETT, Michael, Julian, Edmonton, Alberta T6H 1C4 (CA)
(74) Representative: Robinson, Ian Michael
(86) International application number: PCT/CA1997/000527
(87) International publication number: WO 1998/003695

(56) References cited:
- EP-A- 0 517 411
- US-A- 4 874 664
- US-A- 4 947 046
- PATENT ABSTRACTS OF JAPAN vol. 015, no. 352 (P-1248), 6 September 1991 & JP 03 134819 A (MATSUSHITA ELECTRIC IND CO LTD), 7 June 1991,
- ROBBIE K ET AL: "FIRST THIN FILM REALIZATION OF A HELICOIDAL BIANISOTROPIC MEDIUM" JOURNAL OF VACUUM SCIENCE AND TECHNOLOGY: PART A, vol. 13, no. 6, 1 November 1995, pages 2991-2993, XP000555632 cited in the application
- ROBBIE K ET AL: "Sculptured thin films and glancing angle deposition: growth mechanics and applications" 43RD NATIONAL SYMPOSIUM OF THE AMERICAN VACUUM SOCIETY, PHILADELPHIA, PA, USA, 14-18 OCT. 1996, vol. 15, no. 3, pt.2, ISSN 0734-2101, JOURNAL OF VACUUM SCIENCE & TECHNOLOGY A (VACUUM, SURFACES, AND FILMS), MAY-JUNE 1997, AIP FOR AMERICAN VACUUM SOC, USA, pages 1460-1465, XP002044706

## Description

### FIELD OF THE INVENTION

This invention relates to the deposition and capping of thin films on substrates.

### CLAIM TO COPYRIGHT

A portion of the disclosure of this patent document contains material which is subject to copyright protection. The copyright owner has no objection to the facsimile reproduction by anyone of the patent document, as it appears in the Patent Office patent file or records, but otherwise reserves all copyright rights whatsoever.

### BACKGROUND OF THE INVENTION

In the art of growing thin films, it is known to expose a substrate to an oblique incident vapor flux in conditions of limited adatom diffusion and thus grow a columnar microstructure on the substrate.

The optical properties of the resulting microstructure are dependent in part on the material used, the porosity of the microstructure and the orientation of the columns cf the thin film.

Hamaguchi et al, United States patent no. 4,874,664, describe lateral shifting or rotation of the position of the substrate in relation to the vapor flux to create uniform film growth and film layers that have columns with different orientations in the different layers. In Hamaguchi et al, the entire substrate is rotated in between periods of exposure of the substrate to vapor flux, or the substrate is laterally shifted during exposure to vapor flux.

The angle of the incident vapor flux in the prior art tends to be in the range from near 0° to 70° where the angle is measured between the vapor arrival line and the substrate normal, which may be referred to as the polar angle. For stationary substrates, results have been published for polar angles reaching close to 90°. The angle of growth of the columns is related in a way poorly understood to the angle of incidence of the vapor flux, but is always observed to be smaller, as measured from the substrate normal, than the angle of incidence.

A paper of Azzam, "Chiral thin solid films", Appl. Phys. Lett. 61 (26) 28 December 1992, has proposed rotation of the substrate while it is exposed to the oblique incident vapor flux to generate a helical microstructure having helicoidal bianisotropic properties. The proposed rotation of the substrate is about an axis perpendicular to the surface of the substrate, which is referred to in this patent document as rotation about the azimuth, or variation of the azimuthal angle. No particular polar angle is specified, though a figure shows an angle of less than 60°.

The inventors have also proposed improvements to the methods of Azzam and Hamaguchi, as described in "First thin film realisation of a helicoidal bianisotropic medium", Kevin Robbie and Michael J. Brett, Akhlesh Lakhtakia, J. Vac. Sci. Technol. A18(6), Nov/Dec 1995, P. 2991-2993. In this article, the inventors demonstrate growth of a helicoidal thin film.

US-A-4,947,046 (Kawabata et al) discloses a method for preparing a radiographic image conversion panel in which a vapor flow of photostimulable phosphor is applied to a support at a particular angle of incidence to form a columnar thin film having distinct oblong prismatic crystals separated by fine gaps. A protective layer is proposed, over the columnar thin film. Tile-like plates are provided on the support substrate, so that the prismatic crystals are deposited according to the outline of the tile-like plates.

### SUMMARY OF THE INVENTION

This invention seeks to overcome some of the limitations of the prior art and provide a film forming system method and apparatus that allows for the growth of capped complex microstructures. A method is provided for capping a porous columnar microstructure with a dense film.

According to the present invention there is provided an apparatus and method as set forth in the appended claims. Preferred features of the invention will be apparent from the dependent claims, and the description which follows.

According to the present invention there is provided a method of sculpting vapor deposited thin films, the method comprising the steps of: initially exposing a surface of a substrate to a vapor flux at an oblique incident angle to grow a porous columnar thin film having distinct columns; characterised by: forming a dense cap layer on the columnar thin film, where the dense cap layer forms a bridge between ends of the columns remote from the substrate.

A cap may be formed by rotating the substrate about an axis parallel to the plane of the substrate while exposing the substrate to vapor flux. During capping in this manner, the substrate may be rotated about an axis perpendicular to the plane of the substrate.

A cap may also be formed by exposing the substrate to a vapor flux in conditions of high diffusion length, such that a dense uniform mass is obtained, such as by heating the substrate to nearly the melting point of the material forming the vapor flux.

In a further aspect of the invention, there includes the step of, while initially exposing the substrate to vapor flux, moving the substrate to alter the direction of growth of the columns, as for example by rotating the substrate about a normal to the surface of the substrate to create a helical film growth.

In a further aspect of the invention, a thin film microstructure is provided wherein vapor deposited material extends in distinct columns from a substrate. The columns are capped, and may be supplied with electrodes to form for example a delay line or a variable wavelength optical filter.

In a still further aspect of the invention, the substrate may be provided with small mounds spaced sufficiently close together that growths are confined to grow on the mounds and not between them. In this way, the spacing of the helical growths can be determined in advance of deposition.

These and other aspects of the invention are described in the detailed description of the invention and claimed in the claims that follow.

### BRIEF DESCRIPTION OF THE DRAWINGS

There will now be described preferred embodiments of the invention, with reference to the drawings, by way of illustration, in which like numerals denote like elements and in which:
Fig. 1 is a schematic illustrating prior art understanding of how shadow sculpting forms columnar film microstructures;
Fig. 2 is a schematic showing apparatus according to one aspect of the invention for depositing a thin film on a substrate using a vapor flux, with an exemplary substrate shown in side view, thereby illustrating how polar angle variation alters the incidence of the vapor flux;
Fig. 3 shows the apparatus of Fig. 2 with the substrate in plan view, thereby illustrating rotation of the substrate about a normal to the plane of the substrate;
Fig. 4 shows control elements for use with the apparatus of Figs. 2 and 3;
Fig. 4A shows an arrangement of the azimuthal and polar angle control motors;
Figs. 5A, 5B, 5C and 5D are graphs illustrating polar (Figs. 5A, 5B and 5C) and azimuthal (Fig. 5D) angle variations;
Fig. 6 is a scanning electron micrograph showing helical columns of MgF₂;
Fig. 7A is a side view of a thin film with helical growths deposited on a substrate;
Fig. 7B is a side view of a thin film as in Fig. 7A with a cap, showing electrodes schematically (the electrodes are not necessarily to scale, since in practice each electrode could cover thousands of helixes);
Fig. 7C is a side view of the thin film of Fig. 7B with electrode plates bounding the structure;
Fig. 7D is a side view of a film with cap and electrodes;
Fig. 8 is a side view of a substrate with mounds for pre-determining the location of helical growths; and
Fig. 9 is a plan view of a substrate with mounds showing one particular pattern of mounds.

### DETAILED DESCRIPTION OF PREFERRED EMBODIMENTS

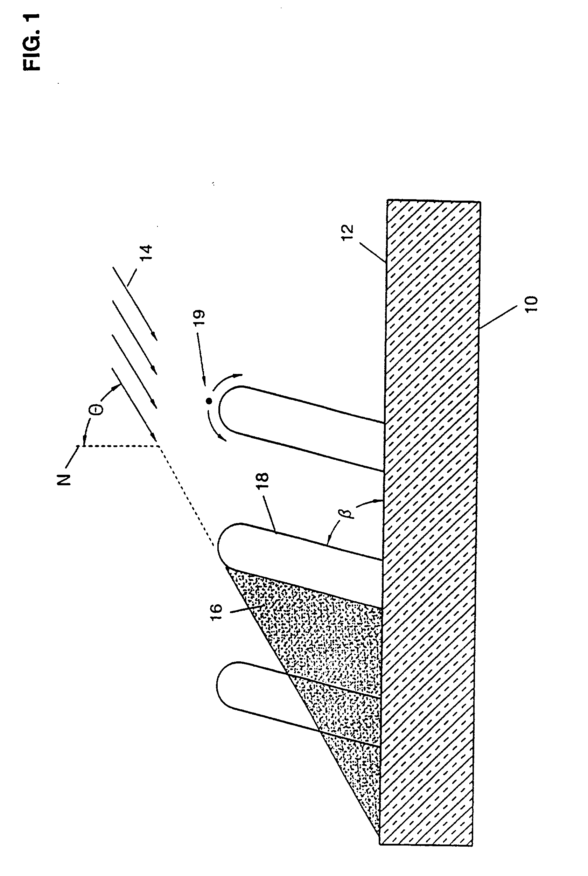

Fig. 1 illustrates the physical process underlying growth of a slanted columnar film microstructure as is known in the prior art. A substrate 10, for example a silicon wafer, has a surface 12 with normal N and is exposed to an oblique incident vapor flux 14 whose angle of incidence, defined in relation to the normal N, is θ. As atoms in the vapor flux 14 are deposited onto the substrate 10, film growth areas atoms shadow adjacent regions 16, preventing deposition of vapor in these regions. Atoms in the vapor flux 14 continue to be deposited in regions that are not shadowed, thus forming columns 18. Atoms diffuse adatomically across the tops of the columns as shown at 19. Planted columnar microstructures will grow if the angle θ is sufficiently large to create the shadowing effect, and there is limited adatom diffusion 19, such that adatom diffusion does not fill in the gaps between columns. In practice, angle θ need only be slightly above 0° to form reasonably defined columns and columnar structures will form in many substances at θ = 0°, though they may be hard to discern under conditions such that the films have high atom diffusion lengths, for example due to high temperatures or materials with low melting points. The angle β of the axis of the columns 18 to the normal N of the substrate is less than θ. The actual relationship between θ and β is poorly understood, but approximations of the relationship are known in the art.

"Oblique" as used in this patent document in relation to an angle means sufficiently departing from 0° that atomic shadowing has an effect on the growth of columnar microstructures. The substrate may be any solid material on which a vapor may be deposited, and will depend on the application. Silicon substrates will be commonly used. The material to be deposited may be any material for which conditions are achievable to support vapor generation and deposition of the vaporized material on the substrate. In some cases, this may require cooling or heating of the substrate. To assist in bonding one vaporized material to another, an intervening layer may be first deposited, as for example using a chromium intermediate layer to bond gold to amorphous silicon dioxide (glass). The processes described here should be carried out in conditions in which the vapor flux arrives at the substrate in approximately a straight line. For this reason, it is preferred that the process be carried out under conditions approximating a vacuum, at less than 0.13 Pa (10⁻³ torr), for example at 0.13x10⁻² Pa (10⁻⁶ torr). At higher pressures, scattering from gas molecules tends to prevent well defined structures from growing. In addition, the material used should have a sticking co-efficient of at least about 0.9 to enable the formation of distinct structures.

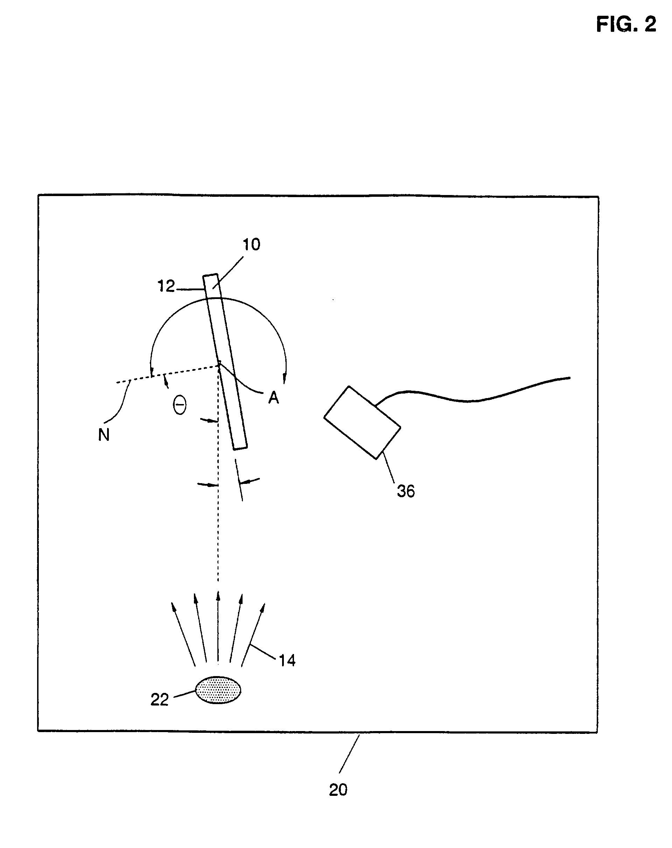

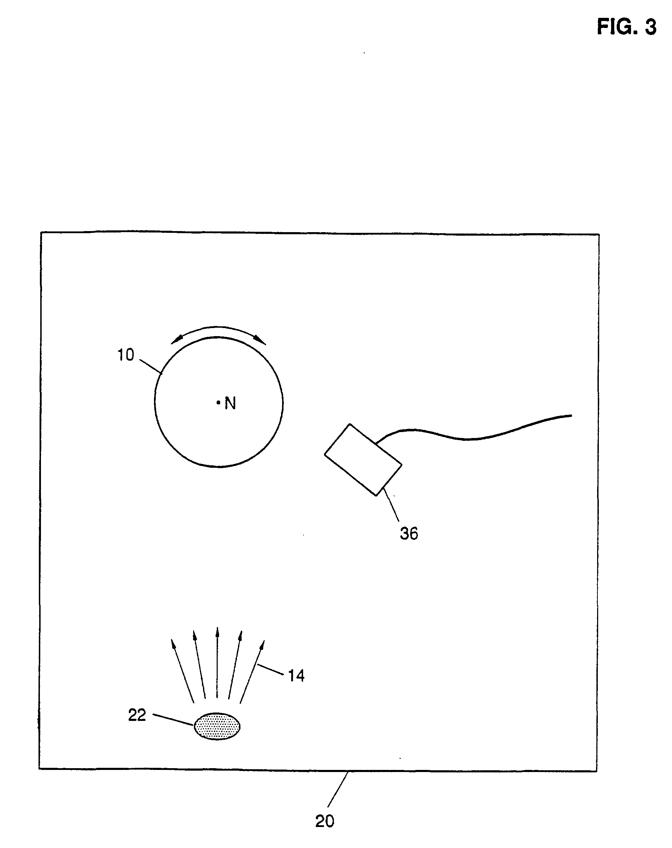

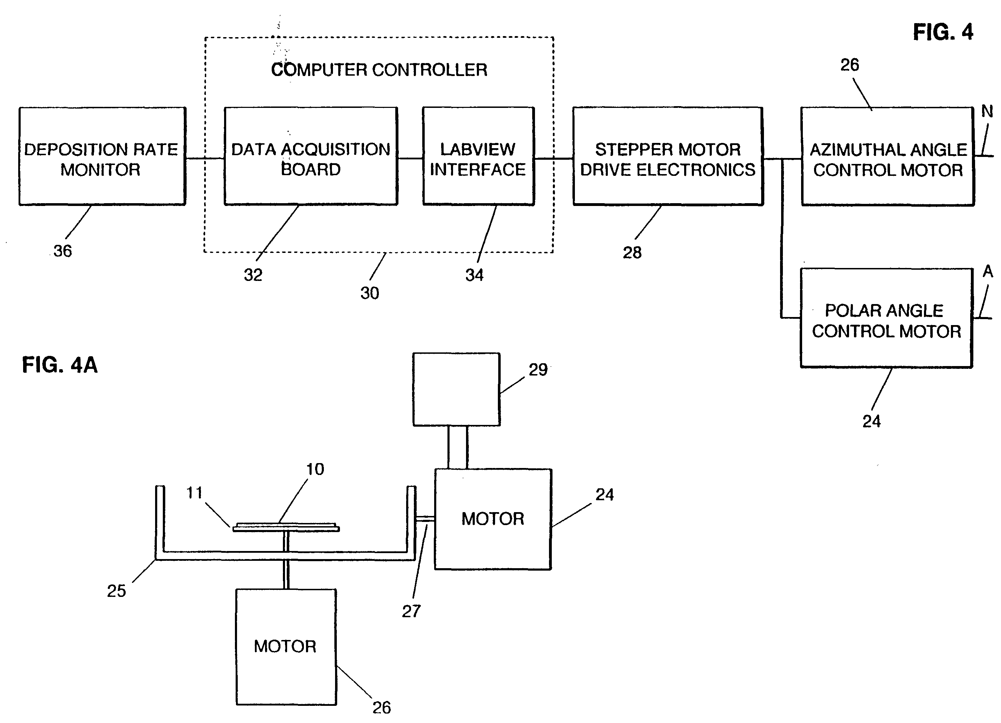

Referring now to Figs. 2, 3 and 4, an apparatus for capping a film according to the invention is shown for growing a thin film on a substrate 10 having a surface 12. A conventional vapor source 22 is located within a vacuum chamber 20. A conventional shutter (not shown) located above the vapor source 22 is used to control whether or not the substrate 10 is exposed to vapor. Various conventional means (not shown separately) for causing the vapor source 22 to emit a vapor flux 14 may be used. A substrate 10 is supported in the vacuum chamber 20 on a motor 24 (Fig. 4) disposed in the vacuum chamber 20 above the vapor source 22. The motor 24 rotates the substrate about an axis A lying parallel to and preferably in the plane defined by the surface 12 of the substrate 10. Rotation of the substrate 10 about axis A alters the polar angle, namely the angle of incidence θ of the vapor flux 14. Motor 26, also disposed in the vacuum chamber 20 above the vapor source 22, has a rotational axis coinciding with the normal N of the substrate 10 and thus alters the azimuthal angle. The polar angle and the azimuthal angles are both measures of the orientation of the surface of the substrate to the incident flux.

As shown in Fig. 4A, the substrate 10 is preferably mounted on a disc 11 which is attached to motor 26. Various mounting arrangements of motor 24 and motor 26 may be used. For example, motor 26 may be mounted on a frame 25, and the frame 25 may be mounted to rotate with the drive shaft 27 of motor 24. Motor 24 itself may be mounted by any of various conventional methods for mounting motors within a vacuum chamber such as on a support 29.

Referring now to Fig. 4, motors 24 and 26 are preferably conventional stepper motors driven by stepper motor drive electronics 28 and controlled by computer controller 30. The computer controller 30 includes a data acquisition board 32 and a software based interface 34 such as LabVIEW™ available from National Instruments. The data acquisition board 32 receives signals indicative of thin film growth on the substrate output from a deposition rate monitor 36 of conventional construction located within the vacuum chamber 20 in a location in which film growth on the deposition rate monitor 36 is representative of film growth on the substrate 10. In response to receiving the output signals from the deposition rate monitor 36, the computer controller 30 instructs the driver 28 to cause the motors 24 and 26 to rotate according to a desired pattern. As described herein, the computer automatically controls the rate of change of the orientation of the surface in response to the output control signals to grow the thin film according to the desired pattern. An exemplary software program for programming the computer controller 30 using LabVIEW™ software is contained in Appendix A. Start and stop signals for vapor deposition may be sent by the computer to a drive for the shutter for starting vapor deposition, or the shutter may be opened manually. Normally, the motors are started before the shutter opens to initiate deposition.

The software receives a deposition rate from the deposition rate monitor. The actual thickness (T2) of the film growing on the substrate is related to the thickness on the deposition rate monitor by an empirically determined scaling factor known as the tooling factor. The software also knows the motor positions at the last time instant (Xfi for motor 24, Xci for motor 26) and receives as input from the operator, the number (N) of turns to be made by the motor 26, the tooling factor (ratio of vertical film growth rate to measured deposition rate), an initial deposition rate estimate, an initial angle of incidence for the vapor flux during sculpted film growth, motor rotation direction, and various parameters that define the desired pattern of growth for the film. The inputs to the computer establish the desired pattern of film growth.

In the case of formation of helical film growths, the pitch w of the helix must be specified, and in the case of a capping layer for a film growth, both the cap thickness (Tc) and number of turns (Nc) of the motor 24 must be specified by the operator. A cap for a columnar thin film is a continuous layer that forms a bridge between the ends of columns remote from the substrate. Due to its continuous nature, the cap is typically considerably more dense than the columnar thin film but may have a limited degree of porosity.

In an embodiment of the invention, the motors 24, 26 are step motors that rotate a fraction of a circle each time instant, ti, ti+1, ti+2 etc. At any given time ti, the computer has just updated the thickness of the film from the deposition rate monitor 36 and changed the motor step rate so that at ti+1, the motor 24, 26 will be at approximately the desired position according to the desired pattern. Between time instants ti and ti+1, the software calculates what the thickness of the film growth will be at ti+2 and calculates how fast the motors must rotate in order to give the desired thickness at ti+2. At ti+2, the computer then reads the new thickness from the deposition rate monitor as well as the motor stepping rates, and adjusts the motor stepping rate so that at ti+3 the film growth pattern will be approximately as desired. The software continues in this fashion until a stop signal is received, for example when the film has reached a desired thickness.

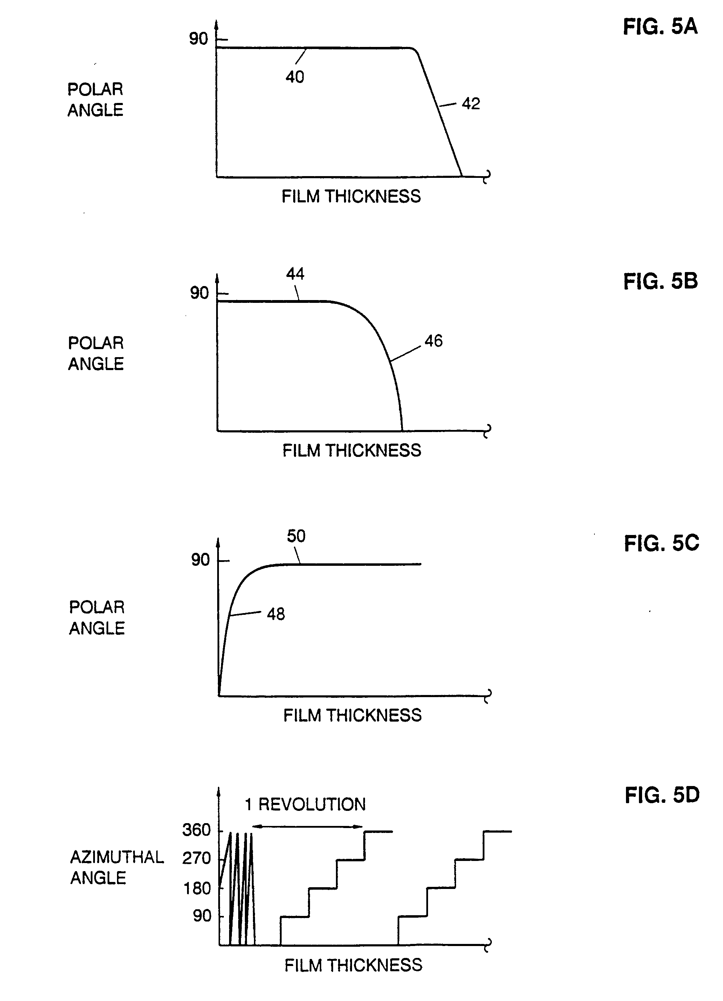

Algorithms for controlling the motors 24, 26 in the case of a helical film with a cap are incorporated in Appendix A, and illustrated graphically in Figs. 5A-5D. For the motor 26, if helical film growth has not reached the desired thickness, that is, T2 is less than w*N, where * indicates multiplication throughout this patent document, then Xc2 is 360°/w*T2, that is, the substrate 10 is rotated to a position equal to 360° times the ratio of T2 to w. If T2 is greater than or equal to w*N, that is, the helical film thickness has been achieved, then during a capping process, Xc2 is 360*N+360*Nc/Tc*(T2-w*N), that is, Xc2 gradually increases from 360*N to 360*(N+Nc) proportionally to the capping layer thickness (T2-w*N). This rotation rate will typically be faster than the rotation rate during helical film growth, depending on the choice of the factor Nc/Tc.

For the motor 24, if helical film growth has not reached the desired thickness, the motor 24 does not change position, hence polar or flux angle remains the same. If T2 is greater than or equal to w*N, then the new motor position Xf2 equals the motor position at the last time instant (Xfi) plus (90 - Xfi) times the ratio of the difference of T2 from w*N to the thickness of the cap (that is, Xfi = Xfi + (90 - Xfi)/Tc*(T2-w*N).

This last formula is represented graphically in Fig. 5A. The polar angle (angle of incidence measured from the normal) is kept constant over an initial period 40, during which the surface of the substrate is exposed to oblique incident vapor flux, and then rotated at a constant angular rate to zero, while continuing to expose the surface to vapor flux. Changing of the polar angle towards zero produces a cap for the sculpted film growths. At zero polar angle, the flux is normally incident. The algorithm for controlling the azimuthal angle results in the substrate rotating N times to achieve a helical film growth of thickness T2 = w*N. During the capping process, the substrate continues to rotate about the azimuth, typically, but not necessarily, at a faster rate than during helical film growth. During the period 40, the substrate 10 may be (a) rotated about a normal to its surface to create helical microstructures, (b) shifted 180° to form zig-zags, (c) translated, (d) kept at a constant orientation to the vapor source, or (e) otherwise rotated or translated to obtain a desired growth pattern under the cap.

Alternatively, the cap for a film growth may be created by exponentially decreasing polar angle as illustrated in Fig. 5B. The algorithm for controlling the polar angle is the same during helical film growth as for the linear cap: the angle is the kept constant. During capping, Xf2 is assigned the value Xfi plus (90-Xfi) times e raised to the power of ((T2-w*N-Tc)/k), where k is the exponential scale factor or time constant (for example, 800). Hence, the polar angle drops monotonically from near 90° to zero as T2 approaches the sum of w*N (the desired thickness of the columnar layer) and Tc (the thickness of the cap). As illustrated in Fig. 5B, polar angle is constant during helical film growth (area 44) and exponentially decreasing to zero in area 46. Rotation speed of the substrate about its normal depends in part on the deposition rate. For MgF₂ at 85° angle of incidence, and a pitch of about 50 nm, the speed is about 2 rpm. Typical rotation speeds used in the process are about 0.2 to 3 rpm. For higher deposition rates, higher speeds will be possible, but the speed should not be so high so as to destroy the distinct columnar features produced by the invention. Although decreasing the polar angle linearly with time also increases the density of the cap layer, it is preferred to use an exponential decrease, wherein the rate of decrease increases with time, since that appears to reduce the probability of high stress in the cap that may lead to fracture.

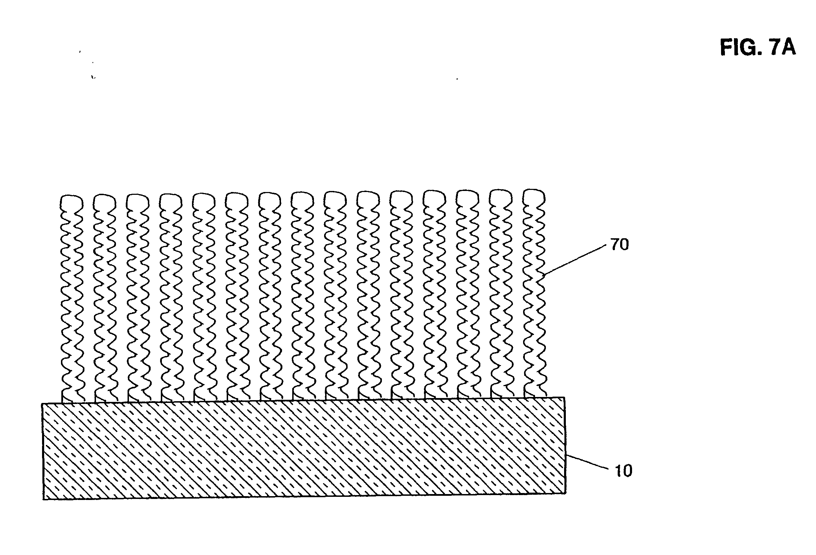

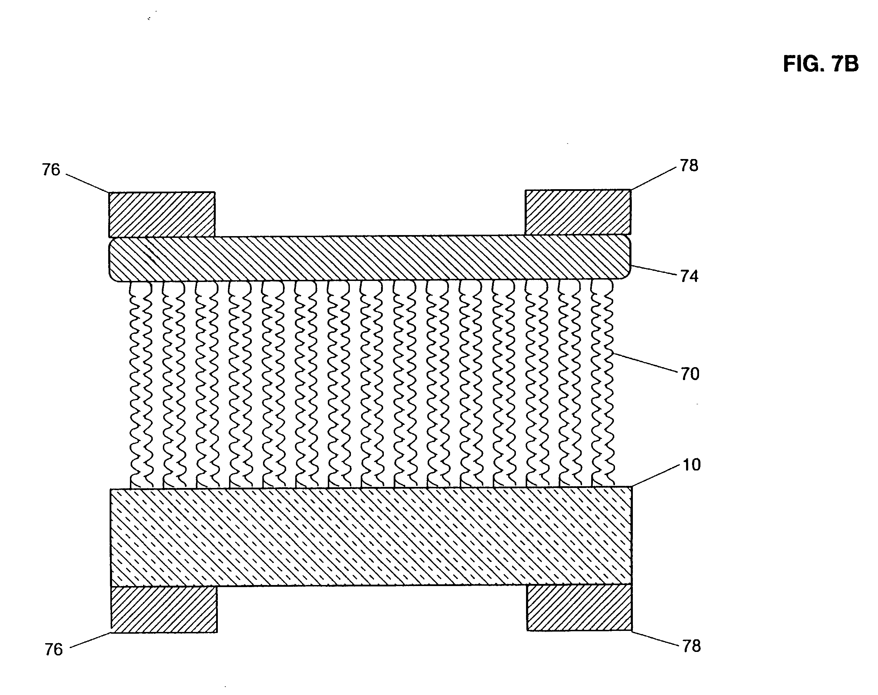

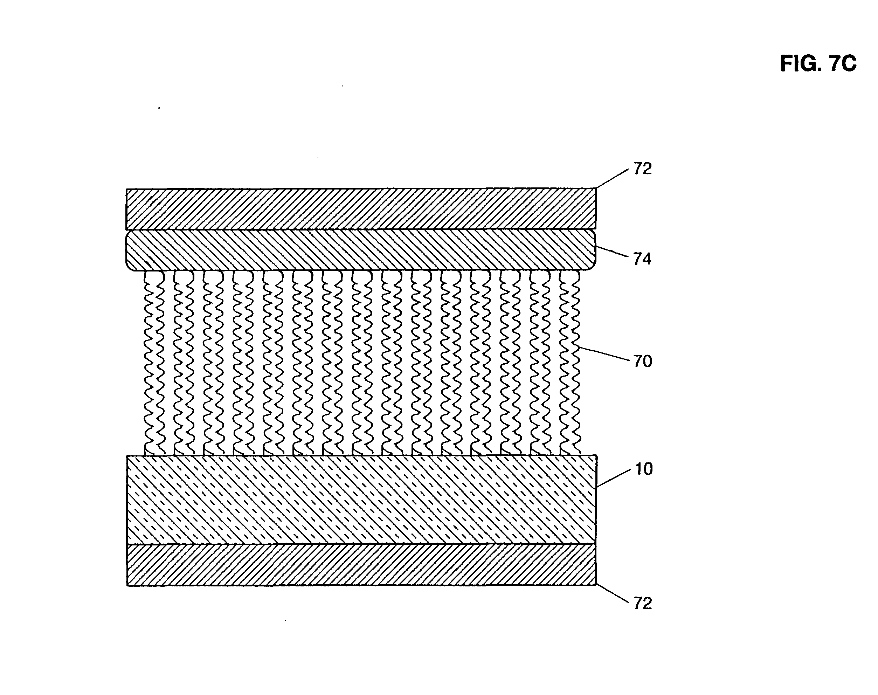

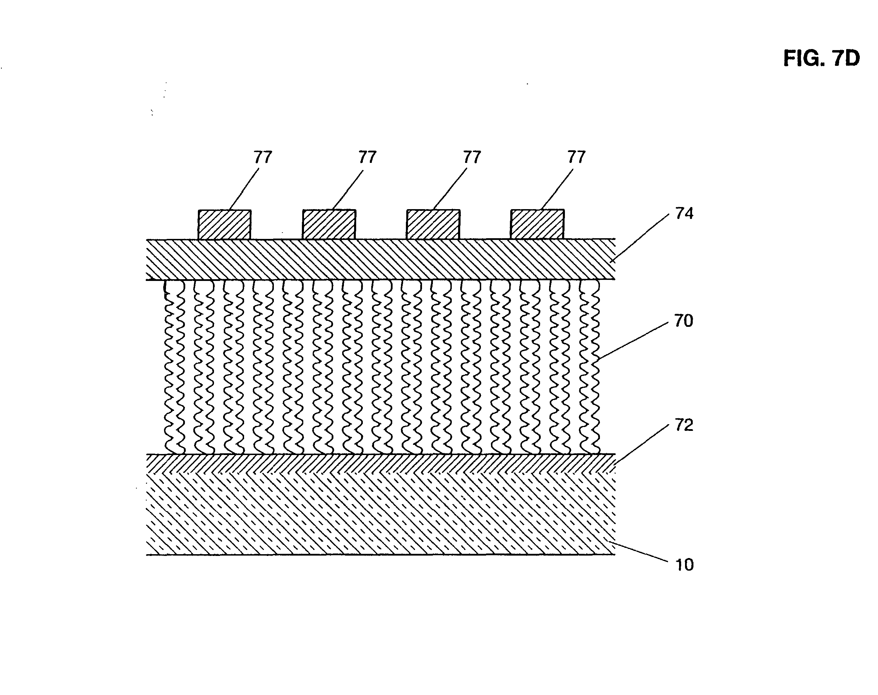

Fig. 7A illustrates a thin film microstructure produced by the process described here with rotation of the substrate about a normal to the substrate. Vapor deposited material extends in distinct (separate from one another) helical columns 70 from the substrate 10. Fig. 7B illustrates the same thin film with the distinct helical columns 70 terminating distally from the substrate 10 in a region of denser material forming a cap 74 for the helical columns. The cap 74 may be produced by changing the angle of incidence of the flux from θ near 90° to zero (as in Fig. 2) as described above (corresponding to rotation about an axis parallel to the substrate surface), or, it is believed on reasonable grounds that, the deposition of the helical columns may be ended under conditions giving rise to a higher diffusion length, as for example higher substrate temperature or changing to a lower melting point material. Increased substrate temperature may be created by exposing the substrate to light from quartz lamps. Temperatures of within about 100°C to 200°C of the melting point of the material being deposited may be required to create conditions of high diffusion length.

In these cases, the substrate 10 is planar. If the substrate 10 is not planar, a mask may be used to expose the substrate 10 to vapor only through slits in the mask and thus control the angle of incidence of the vapor. The mask may then be moved across the substrate to produce the desired thin film by sequential exposure of different portions of the substrate.

The desired pattern of film growth may also be tailored further. For example, a film may be started with a planar film of low porosity by rotating the substrate through exponentially increasing polar angles (zero to near 90°, as seen in Fig. 5C, area 48), with rapid azimuthal rotation (Fig. 5D), and then columns may be grown on the substrate 10, with or without rotation. In one embodiment of a tailored growth pattern, the substrate 10 is maintained at a constant polar angle (area 50 in Fig. 5C) while the substrate is repeatedly (a) rotated azimuthally a set number of degrees, for example 90°, and (b) held at a constant azimuthal position while the film grows obliquely, but linearly. The result is a helix with square sides in this instance. In general, the number of sides of the helix is 360/γ, where γ is the number of degrees the substrate is rotated during periods of deposition.

In a further variation, the rotation of the motor 26 may be reversed during deposition to produce helices with sections of different handedness, one section having a right handed twist, and the other a left handed twist.

Since the deposition rate tends to vary considerably during deposition, to achieve helical growths with constant pitch, the rotation speed may need to be increased and/or decreased during deposition. In addition, by increasing/decreasing rotation relative to the deposition rate, helices with reduced/increased pitch, or helices with graded pitch may be obtained.

In general, the polar angle during an initial deposition period in which helical microstructures are to be produced should be greater than about 80°. The following table shows density of substances deposited as an obliquely incident vapor flux onto a substrate rotating about a normal to the surface of the substrate. The density given is the measured density of the helical film as a percent of the density of a planar film deposited at zero polar angle (normal incidence).

**Table 1**

| Substance | Polar Angle in Degrees | % Density |
|---|---|---|
| Cu | 85 | 46 |
| Cu | 88 | 37 |
| MgF₂ | 85 | 32 |
| CaF₂ | 75 | 19 |
| CaF₂ | 85 | 9.3 |
| SiO | 85 | 32 |
| SiO | 88 | 22 |
| SiO | 85 | 42 |
| SiO | 75 | 89 |
| Al | 85 | 32 |
| Mn | 85 | 52 |
| Cr | 85 | 27 |
| Ag | 85 | 52 |

While the porosity of CaF₂ at a polar angle of 75° is high, CaF₂ exhibits apparently poor structural features at 75°. The high porosity is believed to be due to the fact that CaF₂ molecules have extremely low surface mobility and thus, when molecules of CaF₂ collide with already deposited material, the molecules do not move far and they form very fine microstructures. By contrast, SiO at about 70° polar angle produces a layered structure without well defined helices.

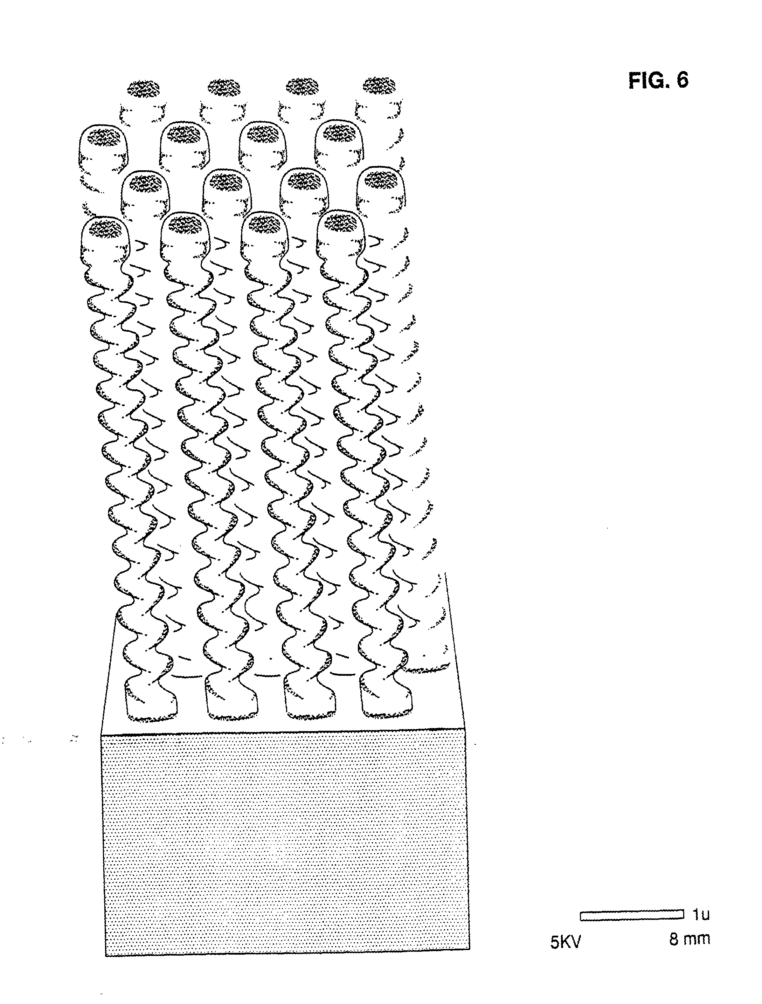

Fig. 6 is a micrograph of helical growths of MgF₂ on a glass substrate. Source material was evaporated by resistively heating a filled tantalum foil boat in a vacuum chamber with pressure 1x10⁻⁶ torr. The polar angle was 85°. The growth shown here used feedback from the deposition rate monitor to ensure a film growth with constant pitch (w). Helices of similar form have been grown with pitches ranging from 50 to 9,000 nm, and in films composed of MgF₂, SiO, CaF₂, Cr, Mn, Ag, Si, Co, ZrO₂, Ti, Permalloy™ (85% nickel, 15% iron alloy) and Cu. It is believed on reasonable grounds that the process will work with any column forming depositable material. Depositable material is column forming when it exhibits limited adatom diffusion and a sufficiently high sticking factor that structures are formed, rather than unformed masses. Tests show that the MgF₂ helical. film growths thus produced exhibit optical rotatory dispersion when λ_{vac} > n_{avg}w, where λ_{vac} is the wavelength of light in a vacuum and n_{avg} is the index of refraction of the MgF₂ film. The MgF₂ film has been found to exhibit optical rotation approximating 340 degrees/mm in a film with 17.3 turns and w = 360 nm. Optical rotation for MgF₂ is counterclockwise for a right-handed helix, and clockwise for a left-handed helix.

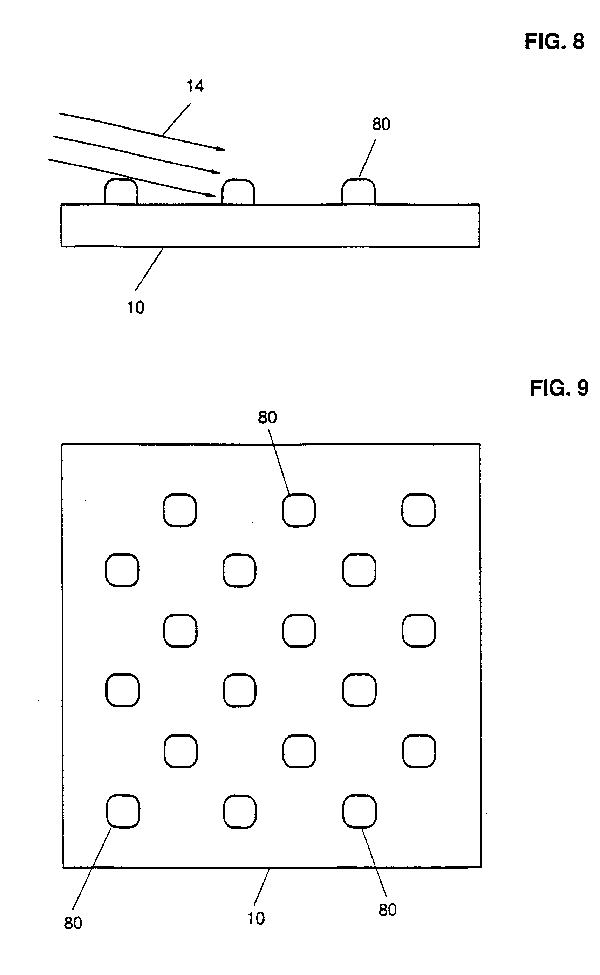

As shown in Fig. 8, small mounds 80 may be micromachined or otherwise formed on the substrate 10 to form preferred locations for helical growths to initiate growth. The mounds 80 should be sufficiently close that shadowing effects prevent deposition of vapor between the mounds. In the case of mounds 80 having a height in the order of 1 micron, the mounds 80 should not be more than a few microns apart in case of the angle of incidence of the vapor being greater than 80°. The desired separation of the mounds 80 depends on the height of the mounds, the angle of incidence of the vapor, and the diffusion length of the vapor. An approximation of the separation L is given by L = htanθ where h is the height of the mounds. The mounds may have any shape, but the diameter is preferably selected so that only one column grows on each mound. The mounds 80 restrict growth of helixes to the mounds 80, and thus the growths can be forced to grow in specific locations. Various patterns of mounds for growing helical collumns can be made such as one shown in Fig. 9. The mounds can be used to grow slanged columns (no rotation of the substrate), and can be used to grow helices (with rotation of the sustrate. Control of the separation of the columnar growths is believed to be useful in applications such as operation of the thin film microstructure as a delay line, where the acoustic wave characteristics depend on the spacing of the helical columns, or use of the thin film microstructure as a biological filter.

Applications for the sculpted thin film helical growths described here include uses as helicoidal bianisotropic media, which are useful in a wide range of applications, as for example as isolators, circular polarizers, quarter-wave and half-wave plates, frequency converters and notch filters. When used as helicoidal bianositropic media, the vapor deposited material should be at least partially transparent at the wavelength of the electromagnetic radiation of interest. The helical growths 70, illustrated in Fig. 7A, deposited on a substrate 10, and grown with rotation of the substrate about a normal to the surface of the substrate, (with or without capping) may be sandwiched between two transparent charged electrodes 72 as shown in Fig. 7C. The electrodes 72 are shown schematically and in practice may be thicker. The electrodes 72 may be made from indium tin oxide or other transparent electrically conducting material and may take the form of plates, or may be patterned, particularly the top electrode. The cap 74 is preferably made from the same material as the helical growths, but need not be. When used with bounding electrodes such as those shown in Fig. 7C, the cap 74 and substrate 10 act as insulators. If insulators are not required in an application, then the substrate 10 may be conducting and the cap may form the upper electrode. As shown in Fig. 7D, plural top electrodes 77 may extend in parallel strips across the top of the cap layer 74. In this embodiment, the lower electrode 72 is formed on top of the substrate 10 and the columns have been grown directly from the electrode 72.

The structure shown in Fig. 7C may be used as an optical filter for circularly polarized light. By applying a charge to the electrodes 72, the electrodes 72 may be pulled together or pushed apart and thus change the pitch of the helices 70. This has the effect of tuning the filter created by the thin film.

In a further application, particularly of the helical growths 70 as illustrated in Fig. 7B with a cap 74, pairs of electrodes 76 and 78 may be placed at opposed ends of the structure spaced from each other. A varying voltage may be applied to one electrode 76 to sequentially compress and expand the structure, with the helical columns thus functioning as microscopic springs, in a direction parallel to the helices 70 in accordance with the varying voltage. The series of compressions and expansions will then propagate along the structure as an acoustic wave to the other end where the electrodes 78, acting as a capacitative acoustic wave sensor, convert the acoustic wave to an electrical signal. Such a device may act for example as an electronic delay line, with a long delay in a very short structure.

When the electrodes 72, 76, 77 and 78 are used as sensing devices, which sense relative movement of the electrodes bounding the thin film structure, the thin film structure may be used for example as a microphone, detecting acoustic waves, a pressure sensor or a force sensor. Piezoelectric materials may be used as the material from which the columns are made.

A capped structure such as the structure shown in Fig. 7C or 7D may also be used as a pump or filter. When the thin film structure is used as a filter, electrodes may not be required. When used as a pump, the embodiment of Fig. 7D may have the electrodes 77 charged sequentially to squeeze the columns 70 and create a pressure wave in fluid in the thin film structure that urges the fluid along the structure.

A capped structure such as the structure shown in Figs. 7C or 7D, with or without electrodes, may be used respectively as an active or passive aerodynamic coating. The structures of Figs. 7B-7D may also be used as mechanical actuators by applying a charge to the electrodes and moving the cap in relation to the substrate on a very fine scale.

The technique of changing the polar angle after columnar deposition may be used to cap films with slanted, curved, vertical or other variably shaped columns.

A cap for a porous microstructure may also be formed by exposing the porous microstructure to conditions in which the atoms in the vapor flux have a higher diffusion length than during formation of the porous microstructure, as by changing the substrate temperature or changing to a lower melting point material in the vapor flux. It will be understood that in performing the inventive steps described herein the film composition may be altered during deposition by changing the material in the vapour flux. This may occur during formation of a porous microstructure, immediately before capping, or even during capping to form a layered, composite structure.

Multiple layered shadow sculpted thin films may be made by growing further columns, including helical columns, on a cap such as cap 74 shown in Fig. 7B, capping the further columns, and growing still further columns. In this way, thin film may be grown with columnar layers interspersed with caps, or flat layers.

Other uses for capped thin films include applications in semiconductor integrated circuit fabrication such as very low dielectric insulators for high speed devices, electroluminescent devices, optical sensing systems, including sensing of adsorbed species, catalyst supports, micro-sieves, biocompatible substrates for tissue growth, thermal barrier coatings on high temperature cycling parts such as jet turbine blades, flat panel displays, thermoelectric cooling panels, solar absorbers, adhesive surfaces, electron emitters, tactile sensing for smart skins, magnetic devices, anti-reflection/low dielectric constant coatings, humidity sensing and microfluid pumping systems.

Sputtering of a material is also believed to be useful as a source of vapor.

A person skilled in the art could make immaterial modifications to the invention described in this patent document without departing from the essence of the invention that is intended to be covered by the scope of the claims that follow.

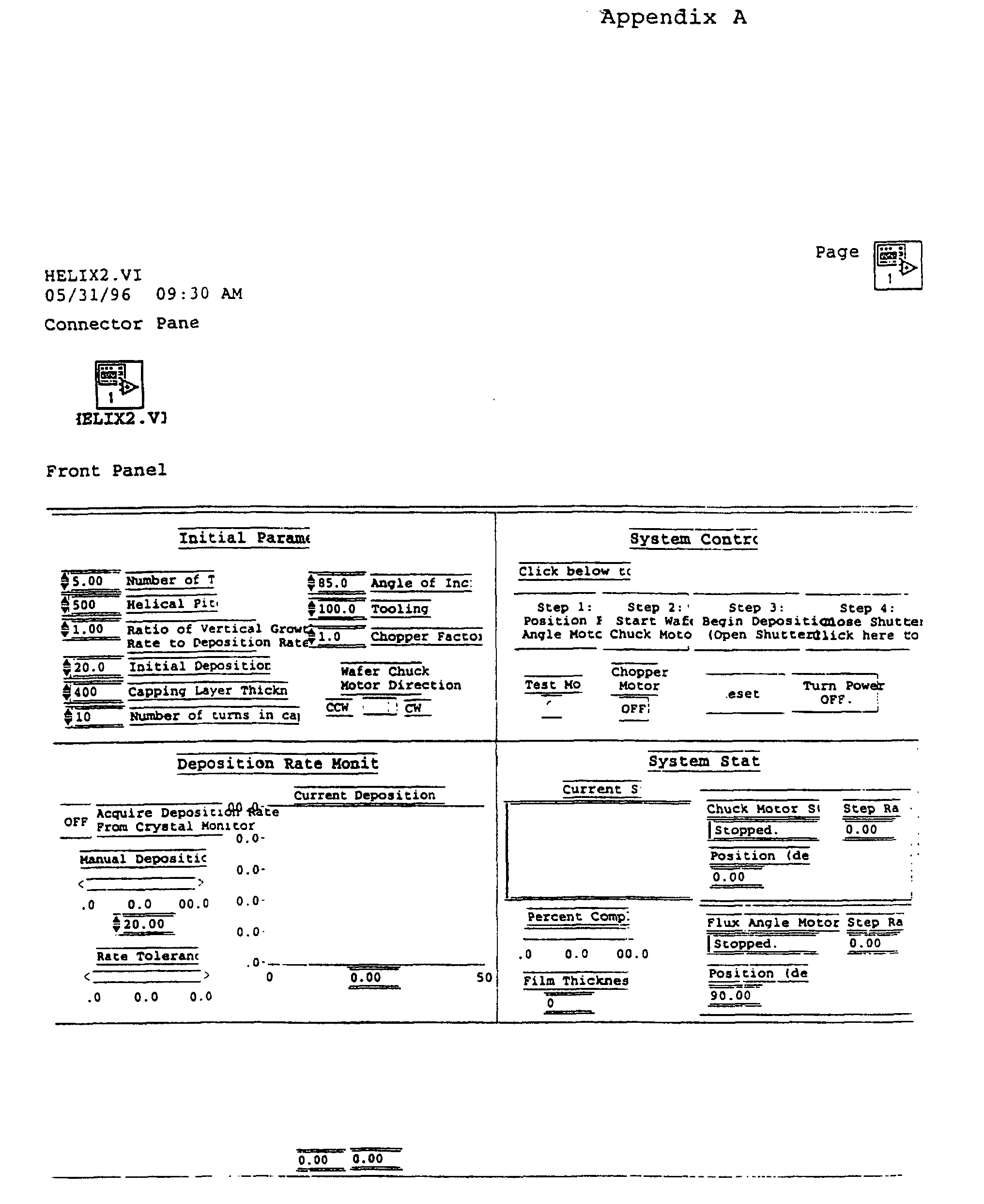

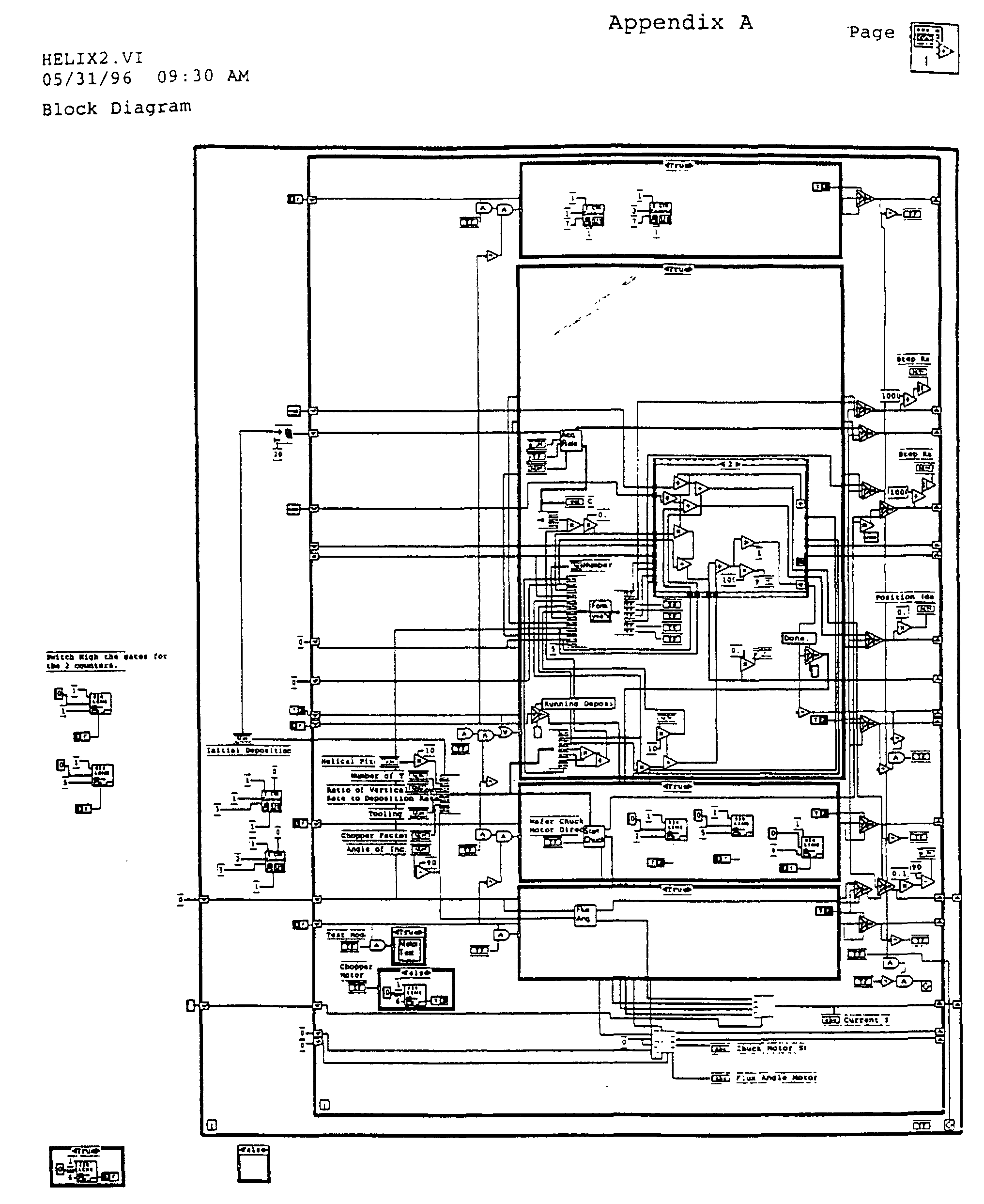

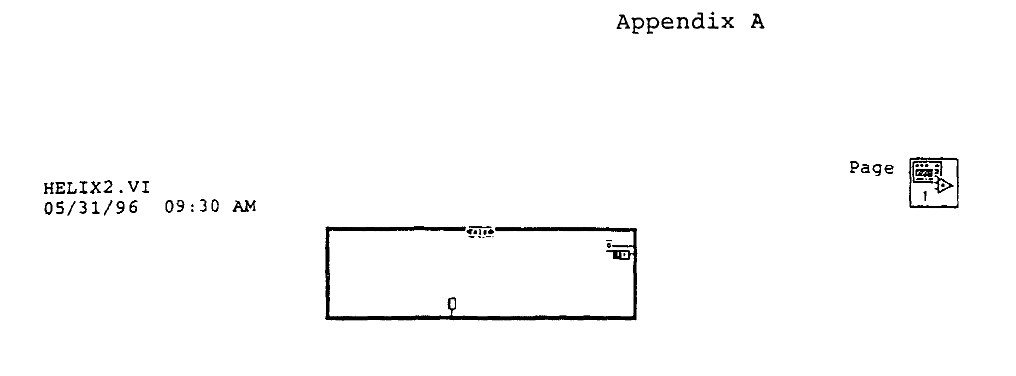

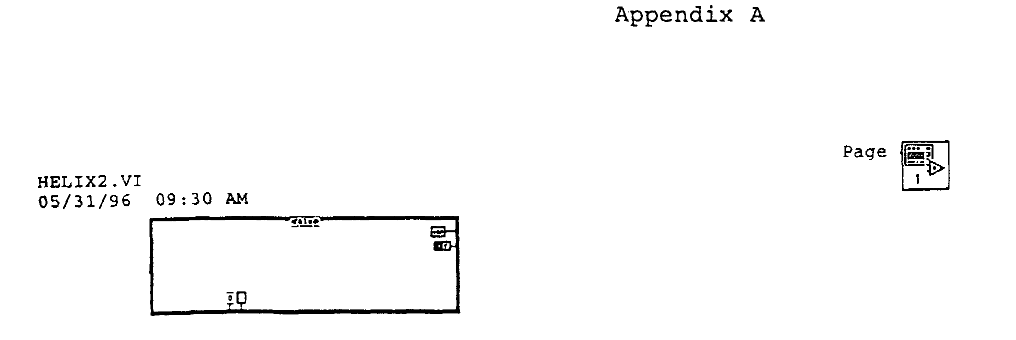

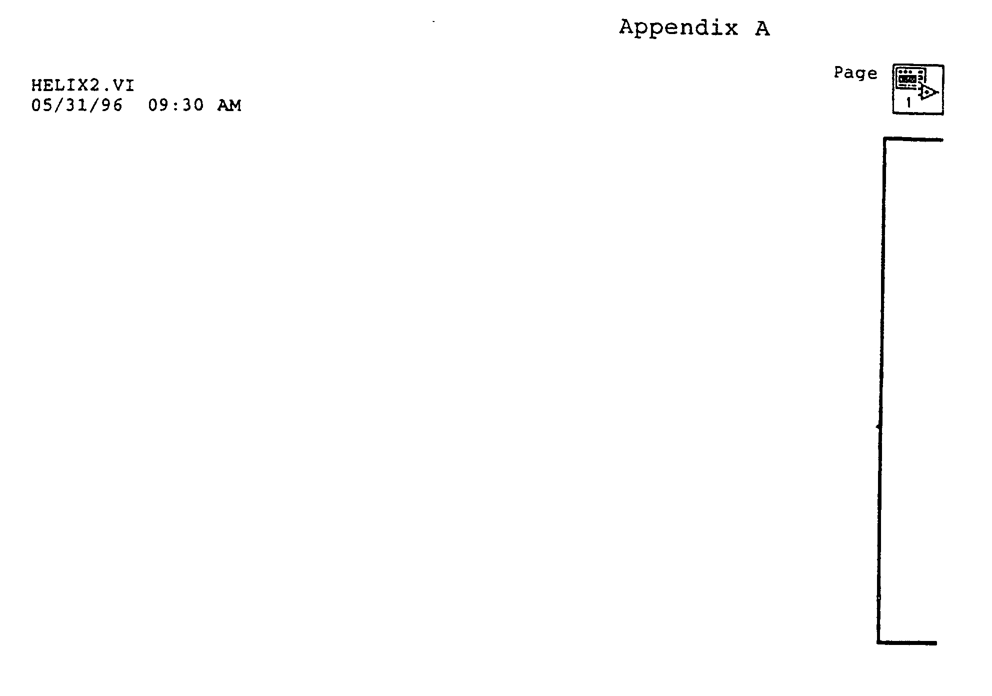

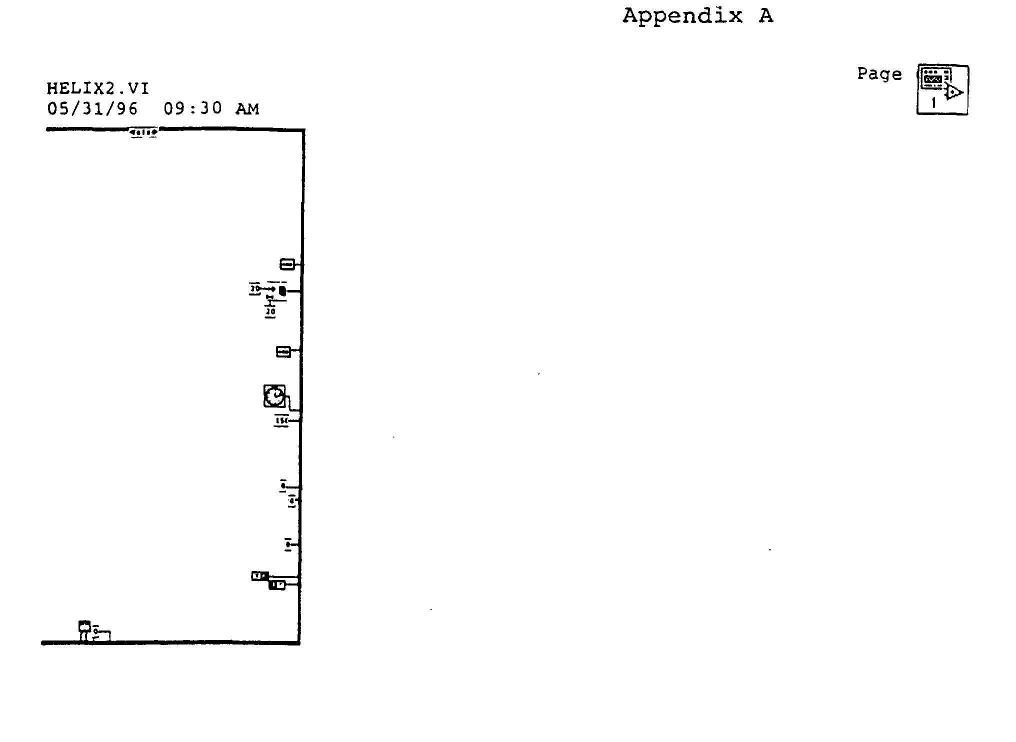

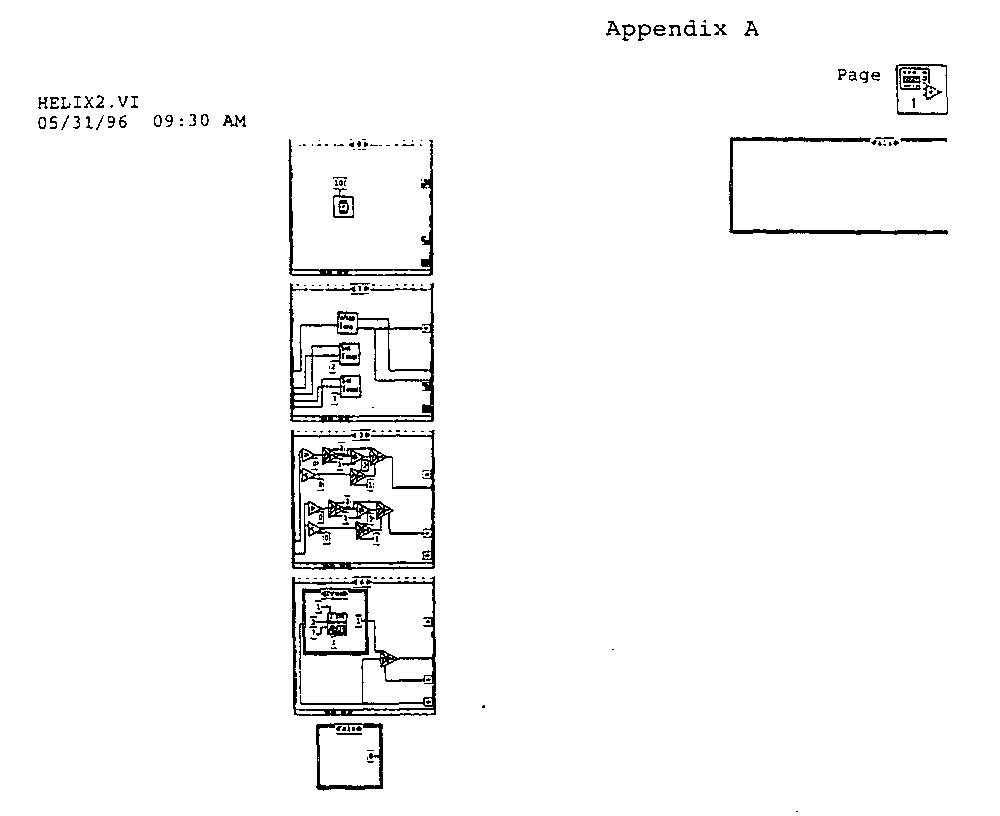

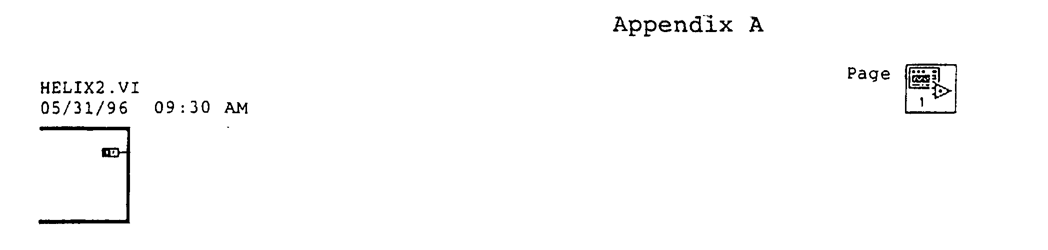

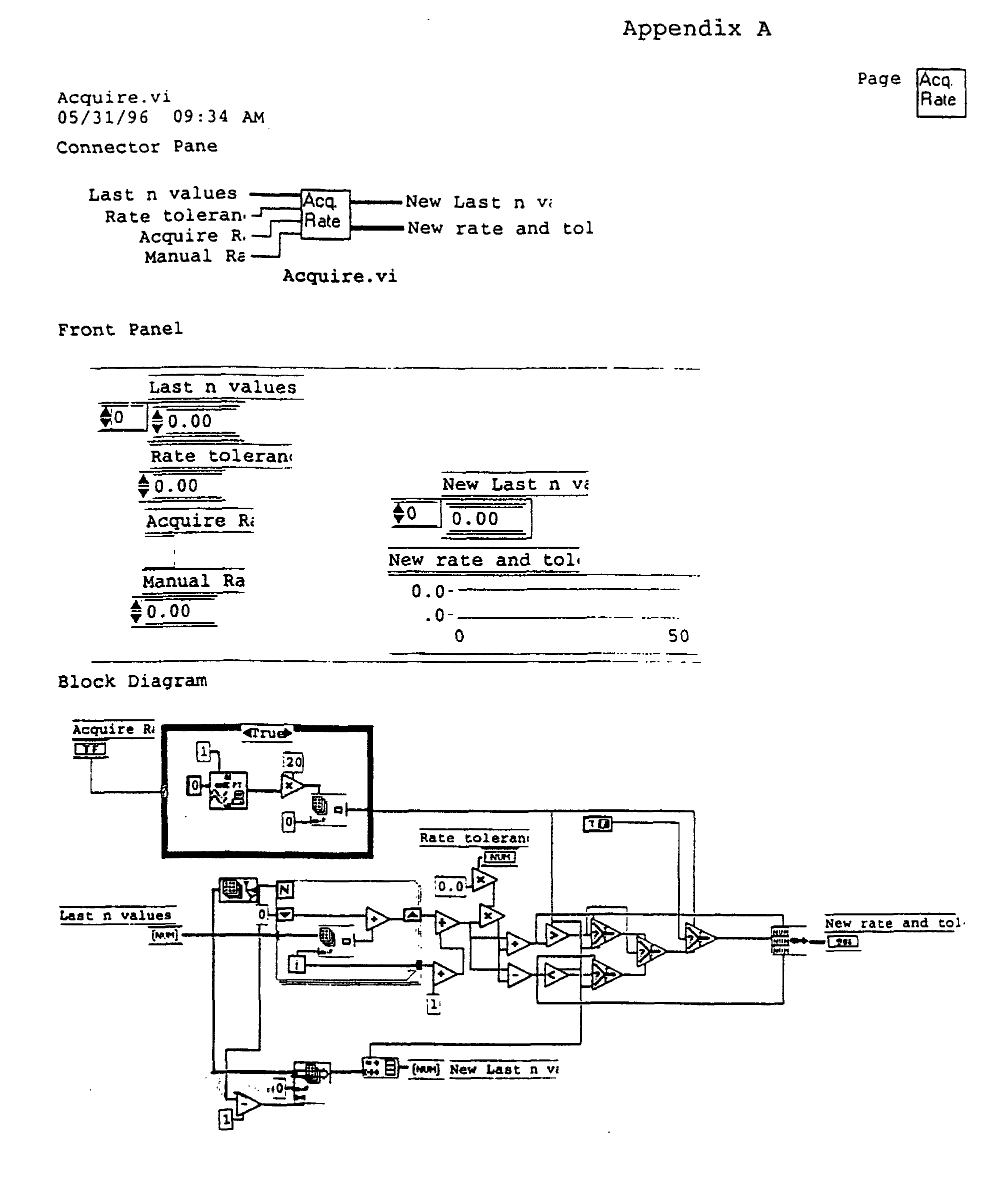

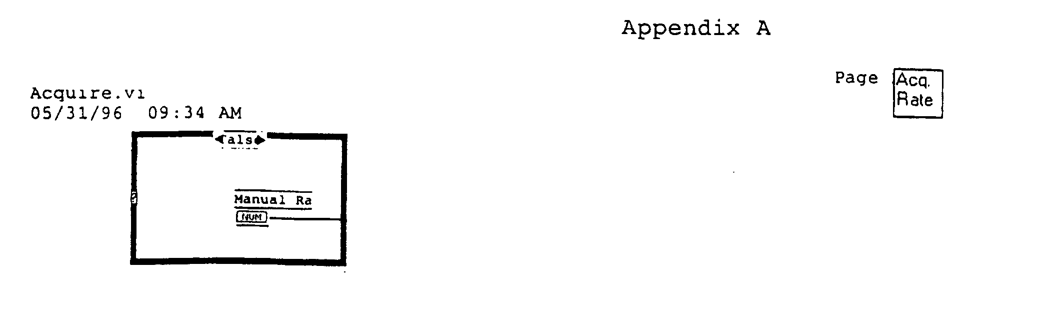

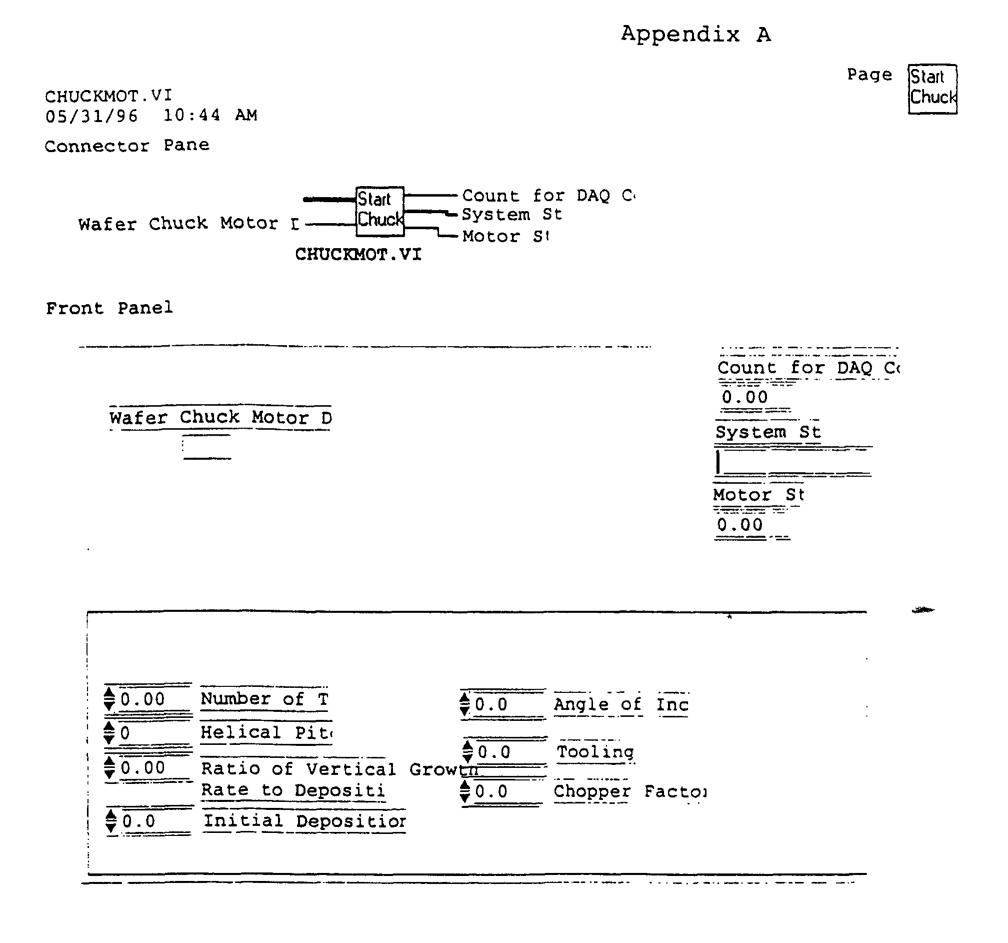

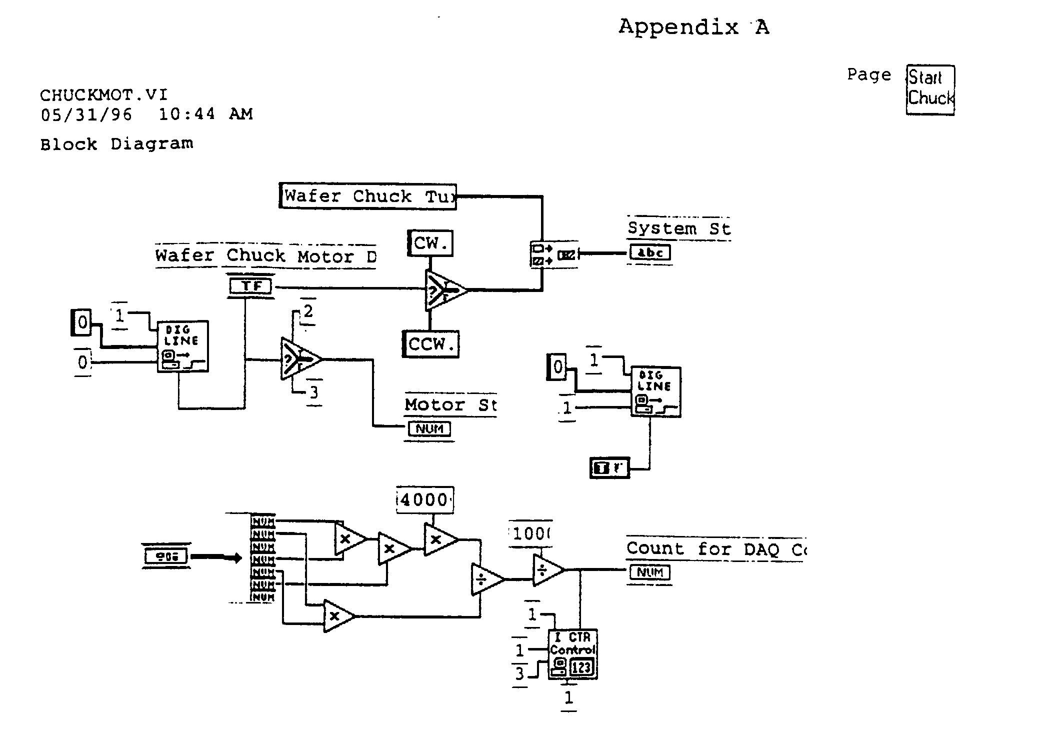

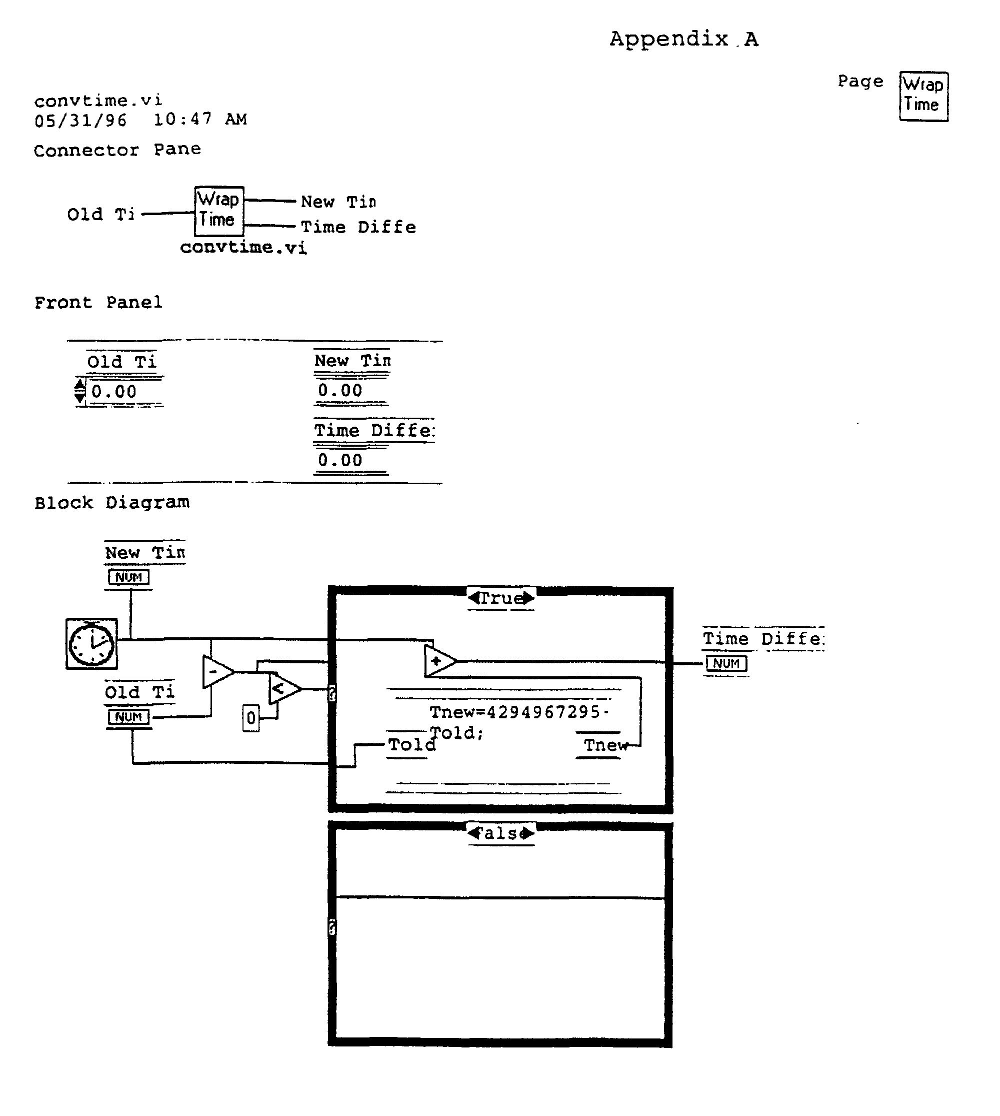

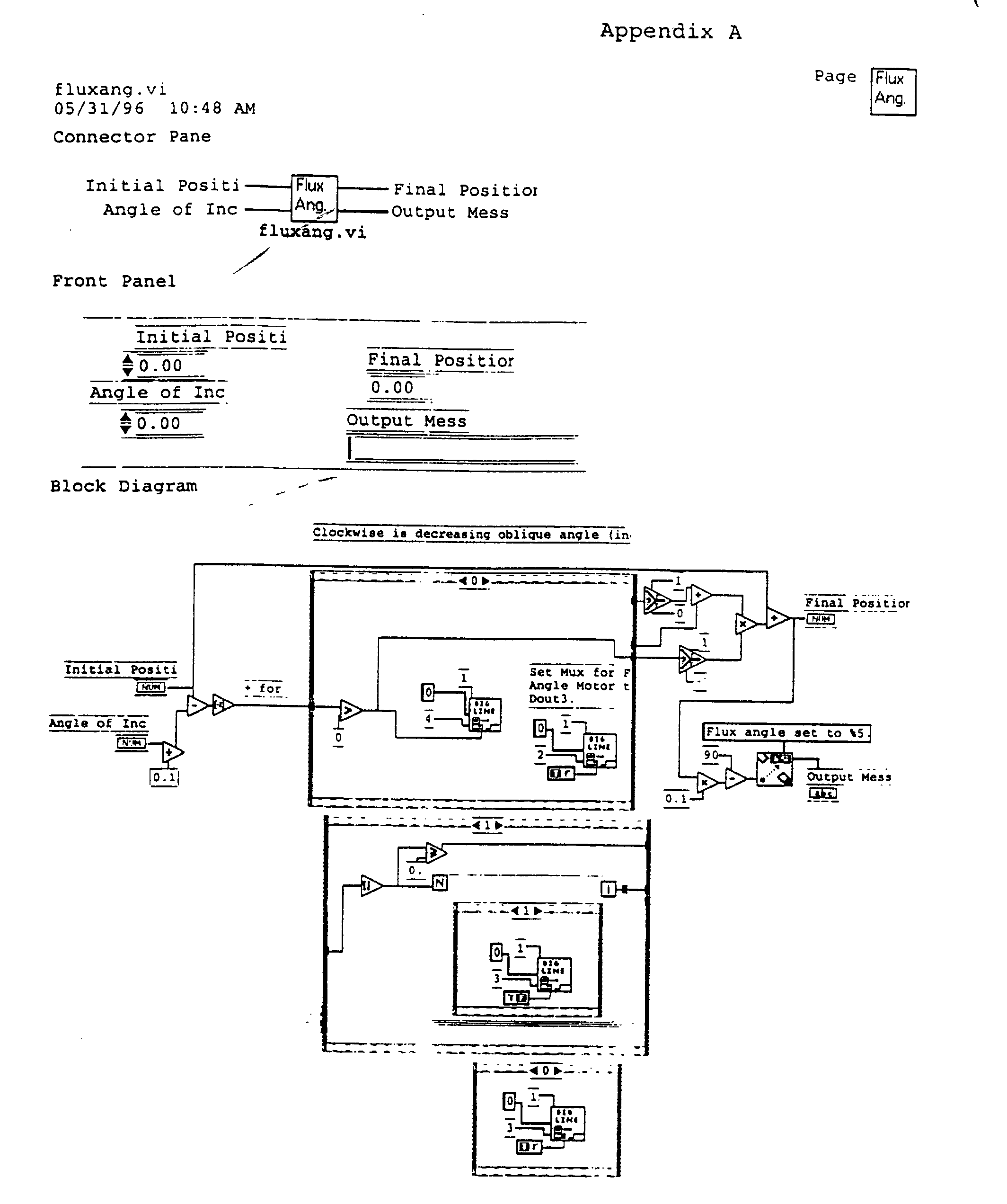

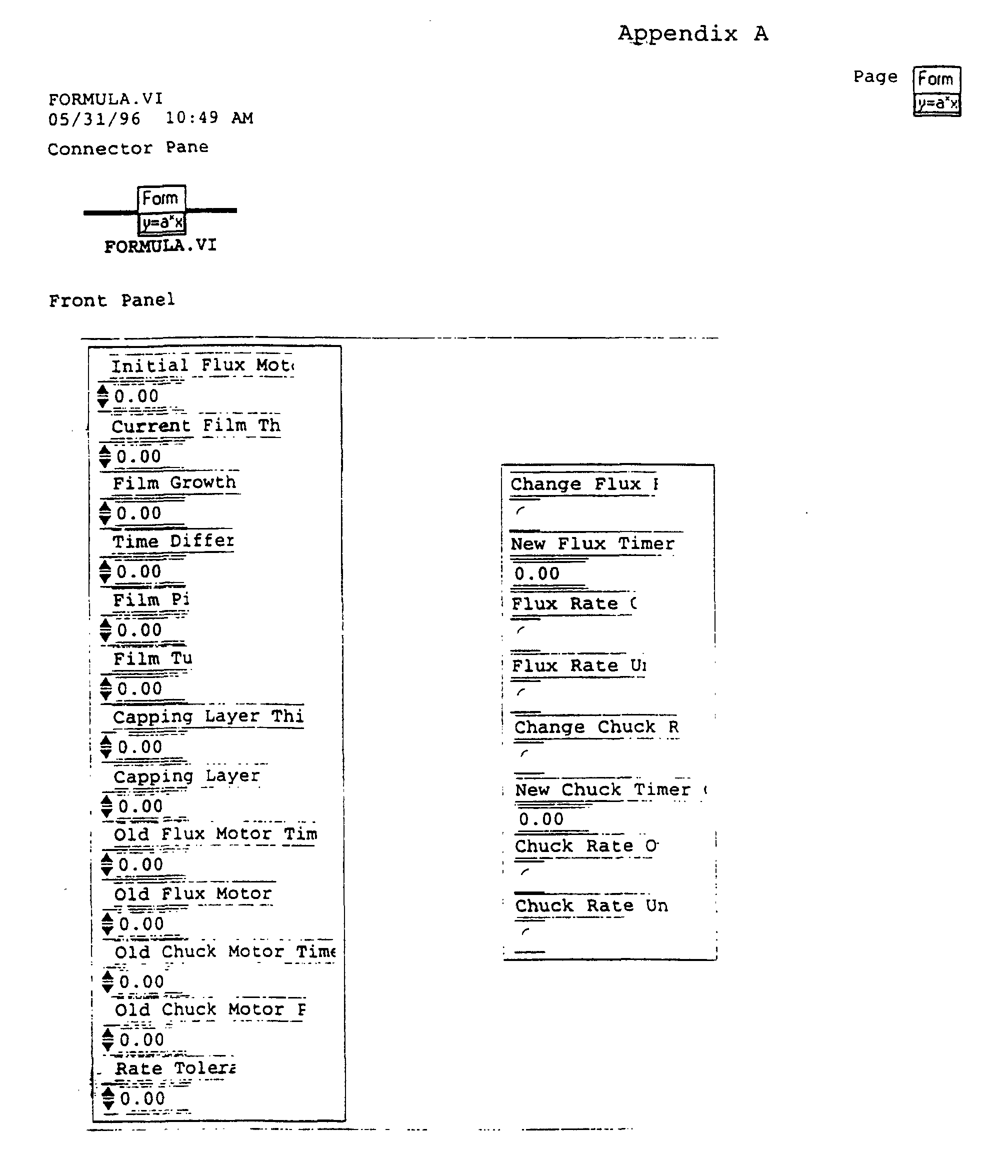

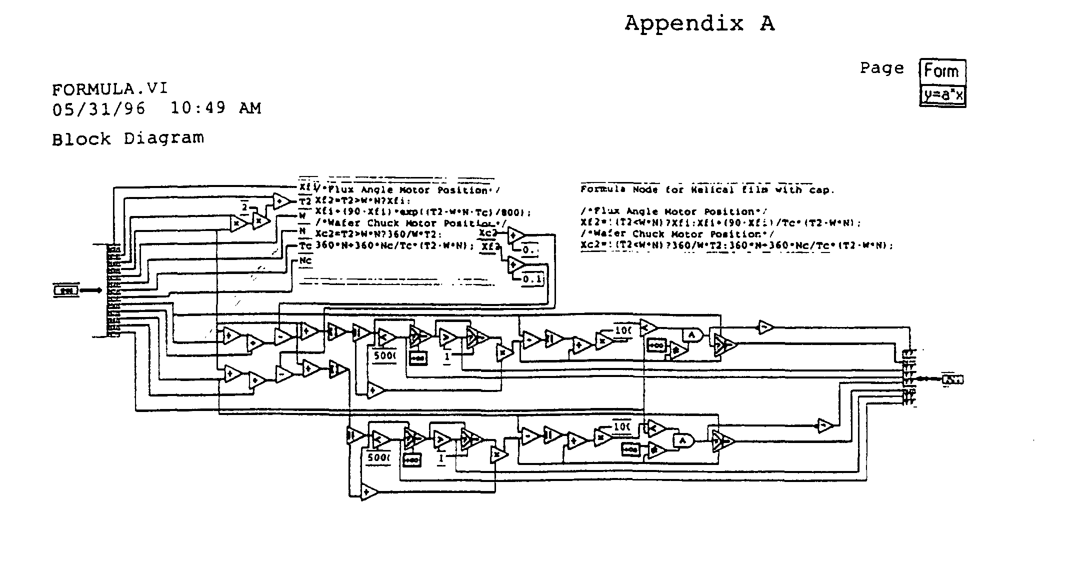

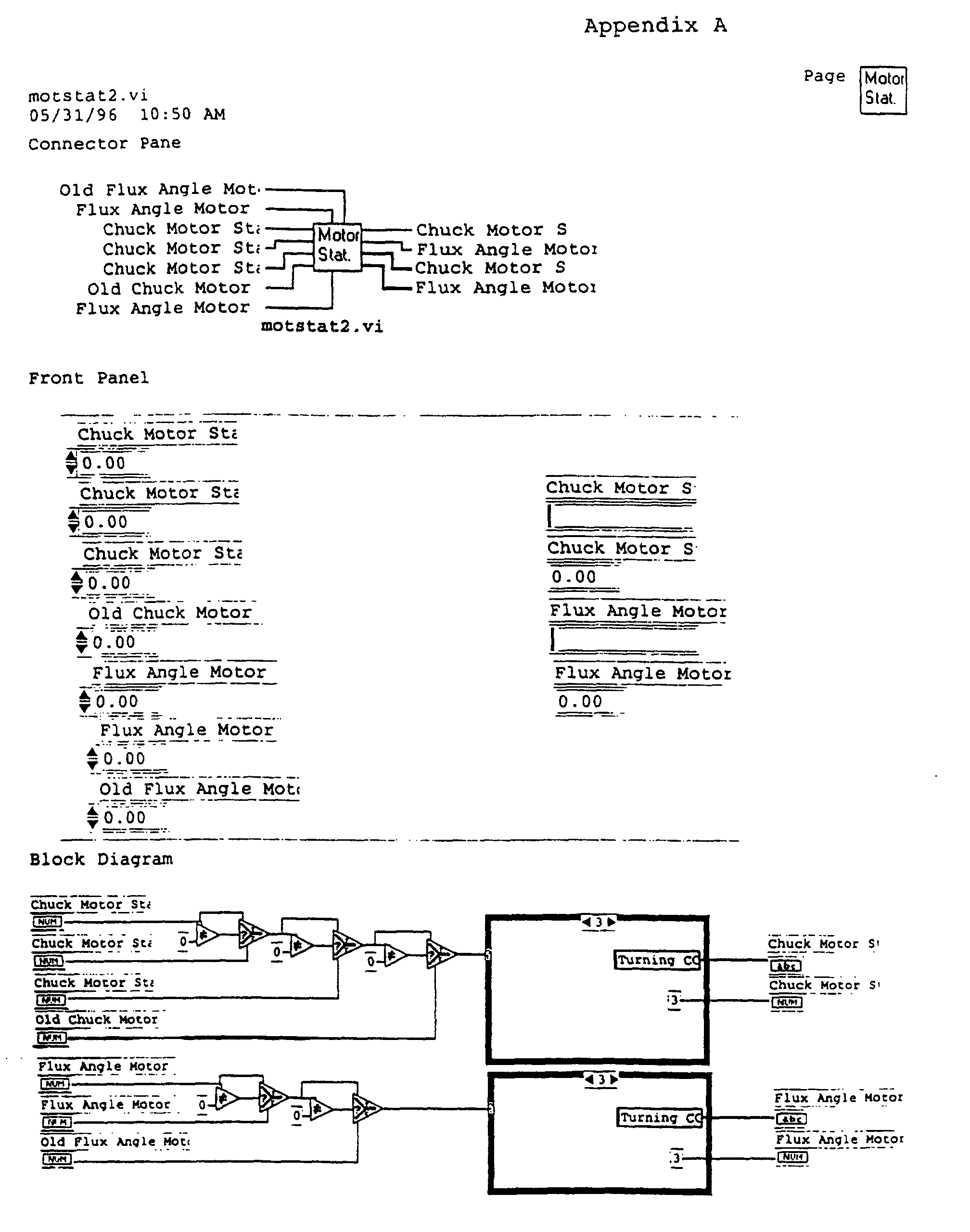

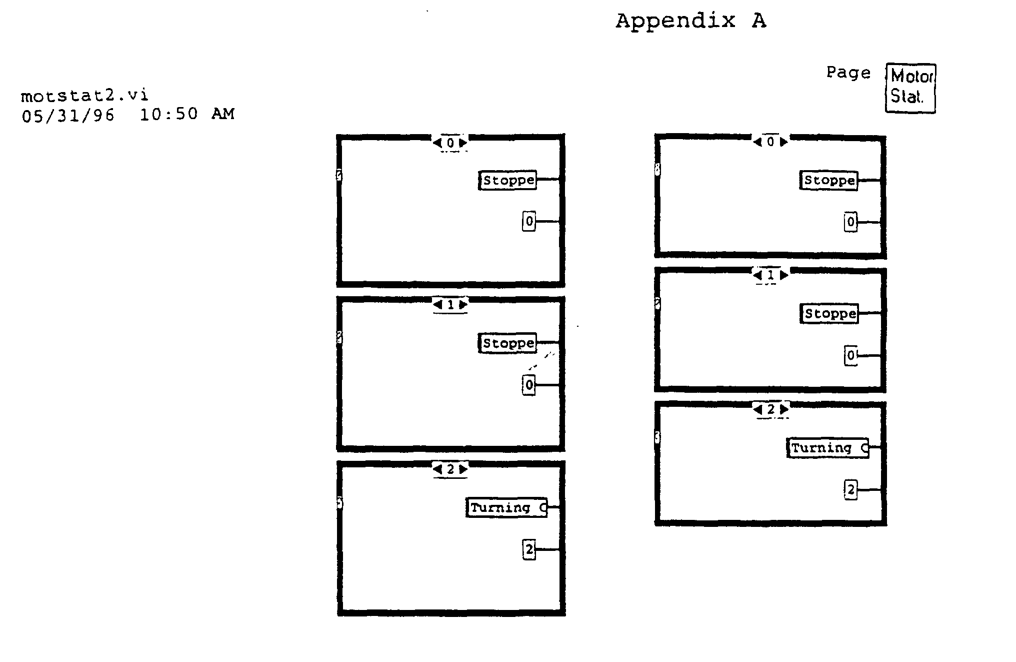

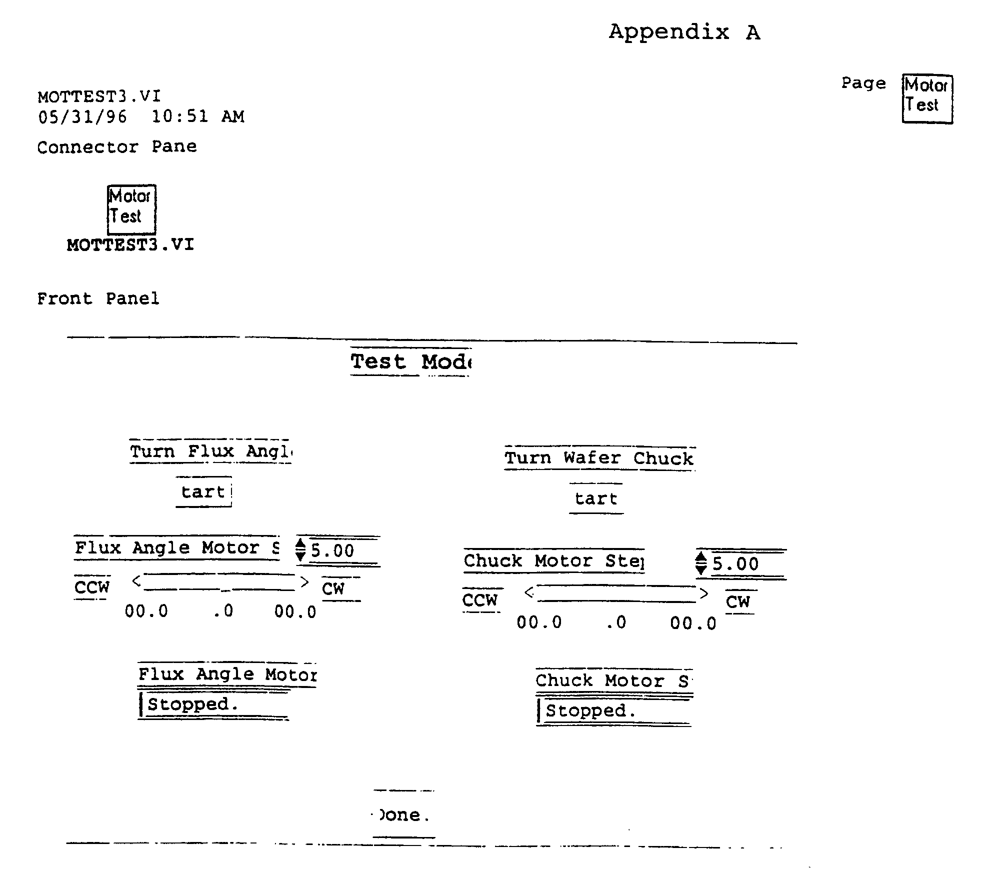

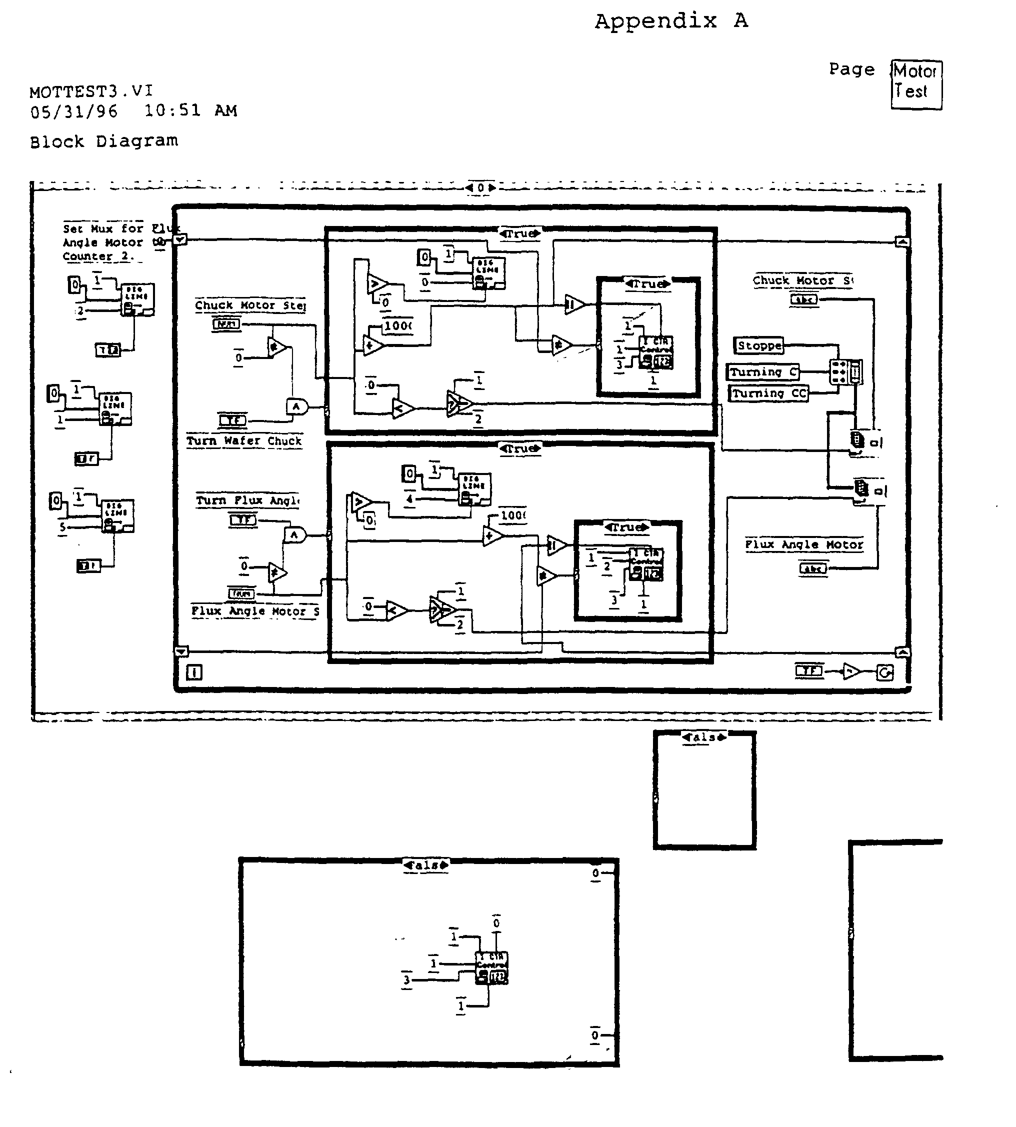

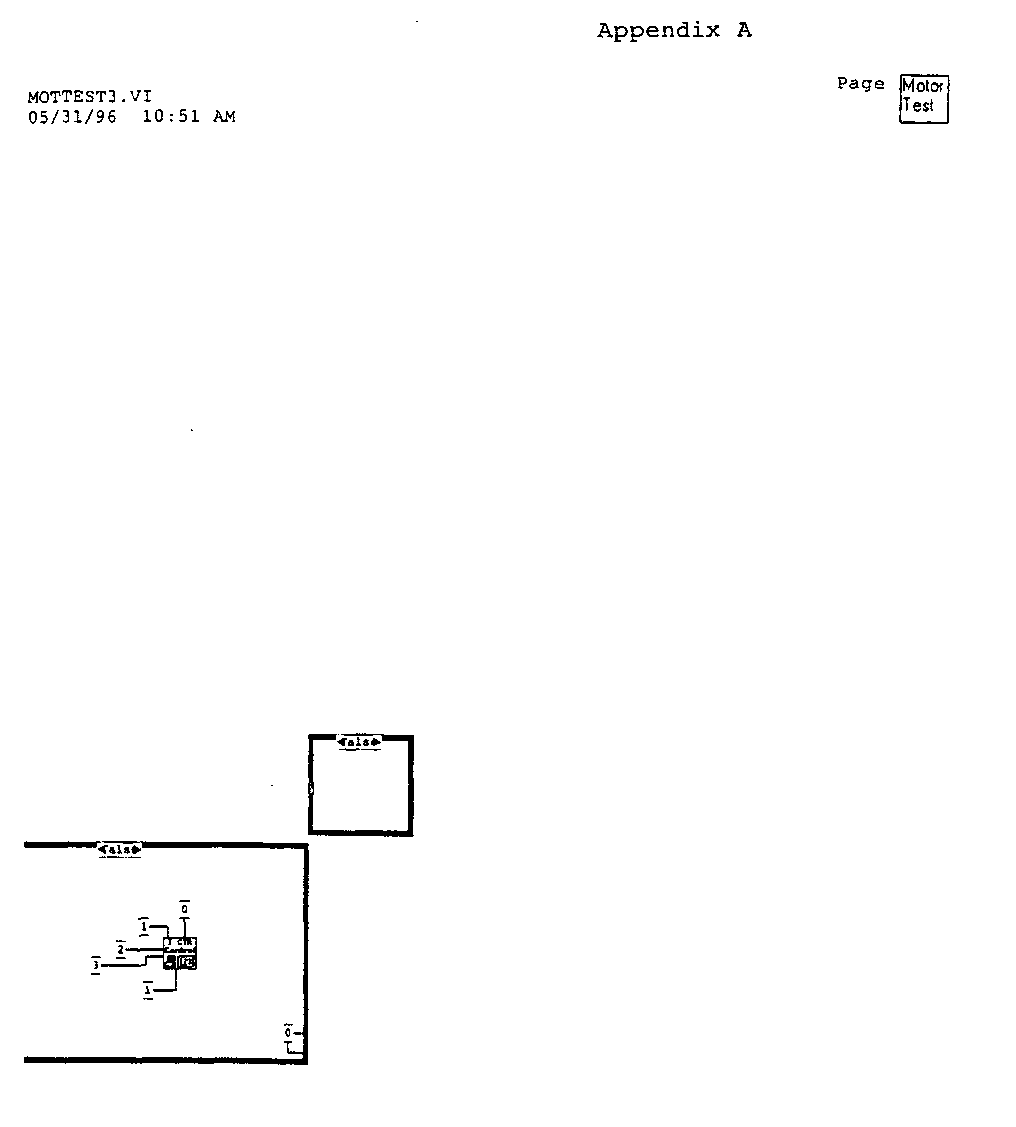

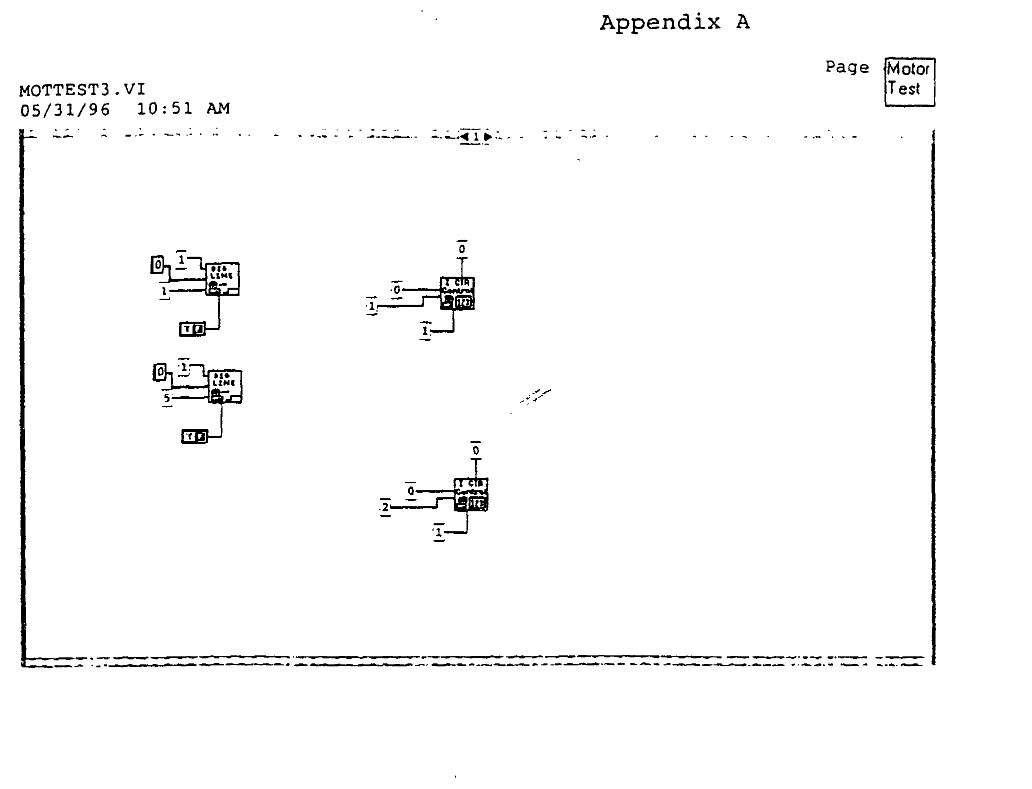

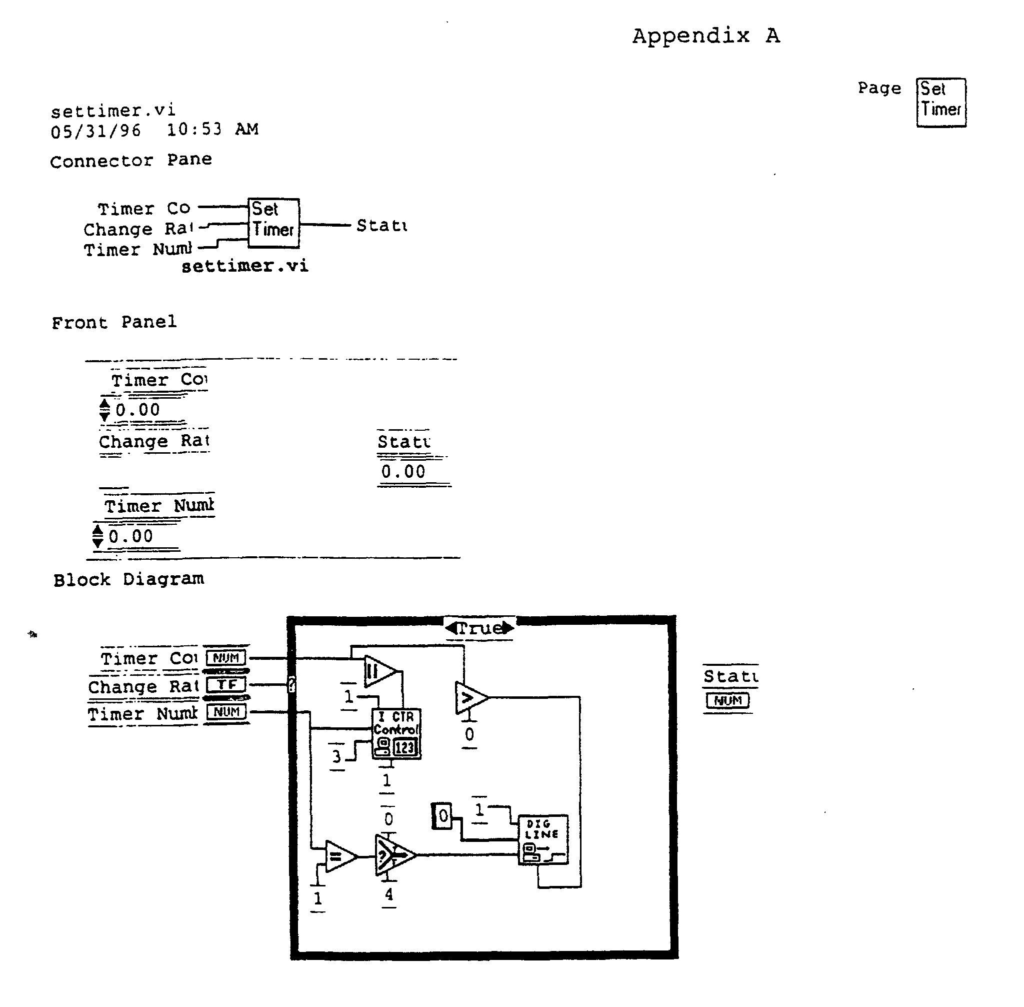

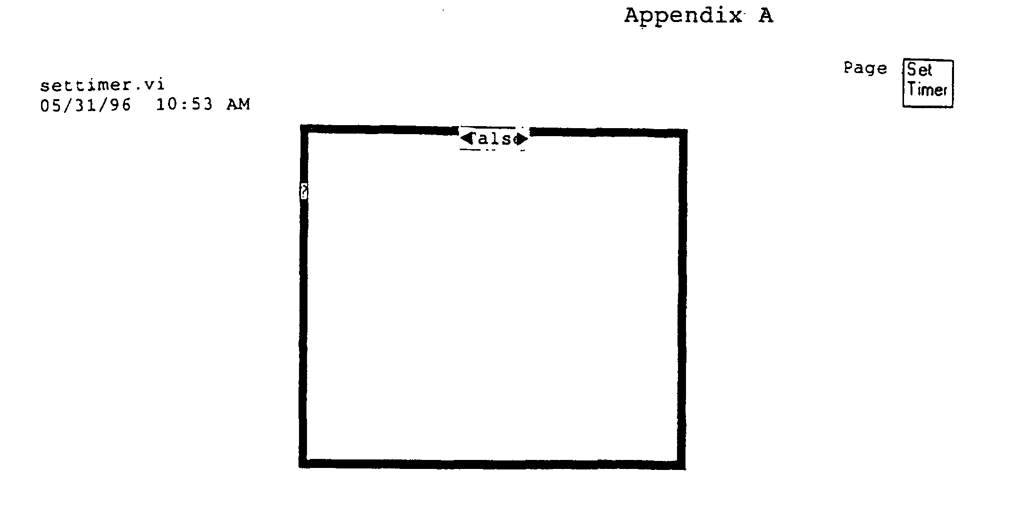

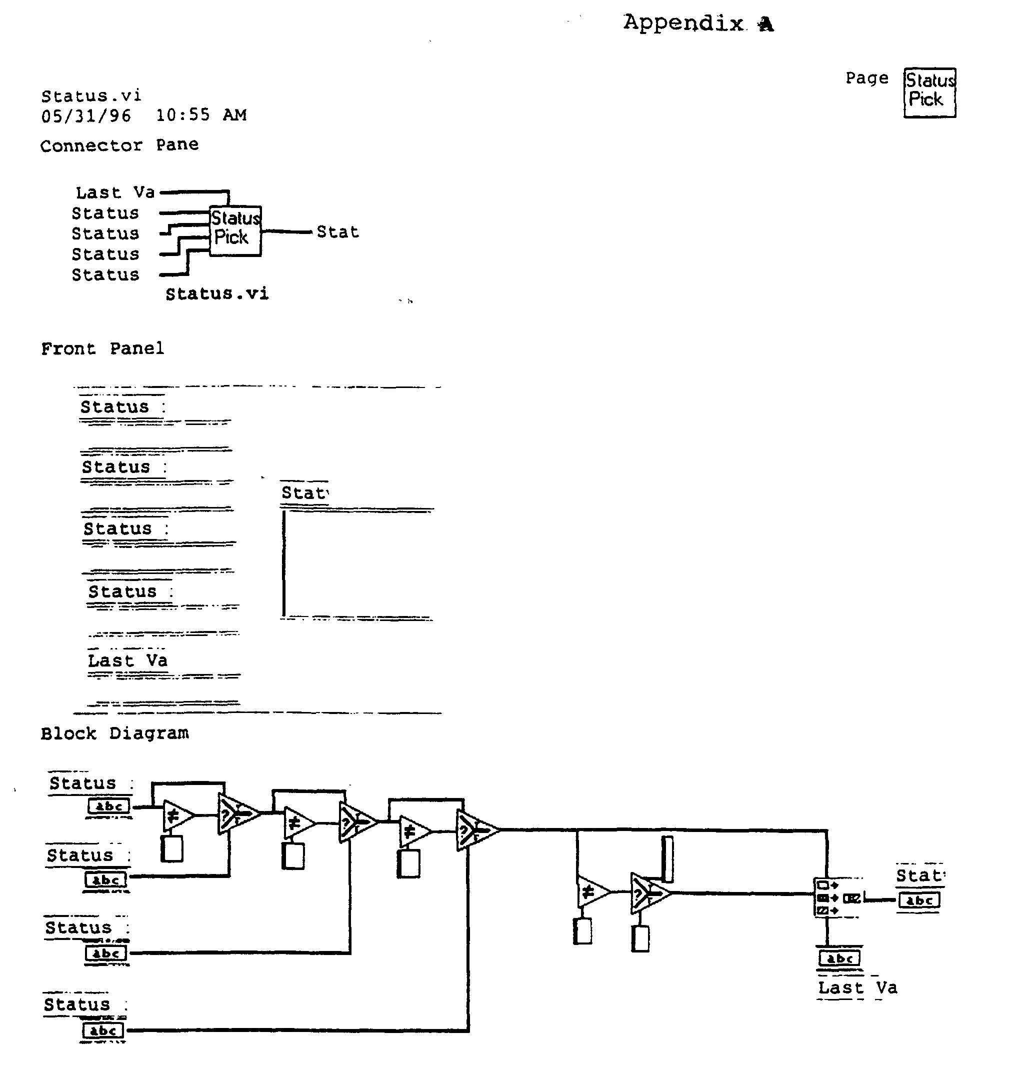

## Claims

1. A method of sculpting vapor deposited thin films, the method comprising the steps of:
initially exposing a surface of a substrate (10) to a vapor flux at an oblique incident angle to grow a porous columnar thin film having distinct columns (70);
**characterised by**
forming a dense cap layer (74) on the columnar thin film, where the dense cap layer (74) forms a bridge between ends of the columns (70) remote from the substrate (10).

2. The method of claim 1 in which forming the cap layer (74) on the columnar thin film comprises:
while exposing the surface to vapor flux, rotating the substrate (10) about an axis parallel to the plane of the substrate.

3. The method of claim 2 further comprising, while initially exposing the substrate (10) to vapor flux, moving the substrate to alter the direction of growth of the columns.

4. The method of claim 3 in which moving the substrate (10) to alter the direction of growth includes rotating the substrate about a normal to the surface of the substrate to establish a helical thin film growth.

5. The method of claim 4 in which the substrate (10) is rotated about the normal axis during the second depositional period.

6. The method of claim 1 further comprising forming the cap layer (74) on the columnar thin film by depositing material, after formation of the columnar thin film (70), under conditions of high diffusion length.

7. The method of claim 6 in which conditions of high diffusion length are generated by heating the surface of the substrate (10).

8. A thin film microstructure, comprising:
a substrate (10);
vapor deposited material extending in distinct columns (70) from the substrate to form a porous columnar thin film; and
**characterised in that**:
the distinct columns terminate distally from the substrate in a region of material forming a dense cap (74) for the columns.

9. The thin film microstructure of claim 8 in which the columns (70) are made from material transparent to electromagnetic radiation.

10. The thin film microstructure of claim 8 in which the cap (74) and substrate (10) are each connected, respectively, to first and second electrodes (78).

11. The thin film microstructure of claim 10 in which each electrode (78) is a plate extending across the respective one of the cap (74) and substrate (10).

12. The thin film microstructure of claim 10 in which the first and second electrodes (78) are connected at one portion of the thin film microstructure and an acoustic wave sensor is attached to the thin film microstructure spaced from the electrodes to permit propagation of acoustic waves through the thin film microstructure from the electrodes to the acoustic wave sensor.

13. The thin film microstructure of claim 8 in which the columns (70) are helical columns.

## Patentansprüche

1. Verfahren zum Bilden von durch Aufdampfen erzeugten Dünnschichten, welches die folgenden Schritte aufweist:
ein anfängliches Aussetzen einer Oberfläche eines Substrats (10) einem Dampfstrom unter einem schiefen Einfallwinkel, um eine poröse, säulenförmige Dünnschicht mit ausgeprägten Säulen (70) wachsen zu lassen,
**gekennzeichnet durch**
Bilden einer dichten Abdeckungsschicht (74) auf der säulenförmigen Dünnschicht, wobei die dichte Abdeckungsschicht (74) zwischen den dem Substrat (10) abgewandten Enden der Säulen (70) eine Brücke bildet.

2. Verfahren nach Anspruch 1, bei der das Bilden der Abdeckungsschicht (74) auf der säulenförmigen Dünnschicht beinhaltet:
Rotieren des Substrats (10) um eine parallel zur Substratebene verlaufende Achse, während die Oberfläche dem Dampfstrom ausgesetzt wird.

3. Verfahren nach Anspruch 2, das außerdem beinhaltet:
Bewegen des Substrats, um die Wachstumsrichtung der Säulen zu ändern, während das Substrat (10) anfänglich einem Dampfstrom ausgesetzt wird.

4. Verfahren nach Anspruch 3, bei dem das Bewegen des Substrats (10), um die Wachstumsrichtung der Säulen zu ändern, ein Rotieren des Substrats um eine Normale zur Oberfläche des Substrats umfasst, um ein wendelförmiges Dünnschichtwachstum aufzubauen.

5. Verfahren nach Anspruch 4, bei dem das Substrat (10) während der zweiten Ablagerungsperiode um die Normalachse rotiert.

6. Verfahren nach Anspruch 1, das außerdem ein Bilden der Abdeckungsschicht (74) nach der Bildung der säulenförmigen Dünnschicht (70) durch Ablagern von Material auf die säulenförmige Dünnschicht unter Bedingungen großer Diffusionslänge beinhaltet.

7. Verfahren nach Anspruch 6, bei dem die Bedingungen großer Diffusionslänge durch Erhitzen der Oberfläche des Substrats (10) geschaffen werden.

8. Dünnschichtmikrostruktur, die ein Substrat (10) und ein aufgedampftes Material aufweist, das sich in ausgeprägten Säulen (70) vom Substrat weg erstreckt, um eine poröse säulenförmige Dünnschicht zu bilden, und die **dadurch gekennzeichnet ist, dass** die ausgeprägten Säulen im Abstand vom Substrat in einem Bereich von Material enden, das eine dichte Abdeckung (74) für die Säulen bildet.

9. Dünnschichtmikrostruktur nach Anspruch 8, bei der die Säulen (70) aus einem Material bestehen, das für elektromagnetische Strahlung durchlässig ist.

10. Dünnschichtmikrostruktur nach Anspruch 8, bei der die Abdeckung (74) und das Substrat (10) jeweils an erste bzw. an zweite Elektroden (78) angeschlossen sind.

11. Dünnschichtmikrostruktur nach Anspruch 10, bei der jede Elektrode (78) eine Platte ist, die sich jeweils quer über die Abdeckungsschicht (74) bzw. das Substrat (10) erstreckt.

12. Dünnschichtmikrostruktur nach Anspruch 10, bei der die ersten und zweiten Elektroden (78) an einen Bereich der Dünnschichtmikrostruktur angeschlossen sind und ein akustischer Wellensensor im Abstand von den Elektroden an der Dünnschichtmikrostruktur angebracht ist, um eine Fortpflanzung von akustischen Wellen durch die Dünnschichtmikrostruktur von den Elektroden zum akustischen Wellensensor zu ermöglichen.

13. Dünnschichtmikrostruktur nach Anspruch 8, bei der die Säulen (70) wendelförmige Säulen sind.

## Revendications

1. Procédé de sculpture de films minces déposés en phase vapeur, le procédé comprenant les étapes suivantes :
l'exposition initiale d'une surface d'un substrat (10) à un flux de vapeur selon un angle incident oblique pour faire croître un film mince en colonnes, poreux, ayant des colonnes distinctes (70) ;
**caractérisé par**
la formation d'une couche de couverture dense (74) sur le film mince en colonnes, la couche de couverture dense (74) formant un pont entre les extrémités des colonnes (70) à l'écart du substrat (10).

2. Procédé selon la revendication 1, dans lequel la formation de la couche de couverture (74) sur le film mince en colonnes comprend :
tout en exposant la surface au flux de vapeur, la rotation du substrat (10) autour d'un axe parallèle au plan du substrat.

3. Procédé selon la revendication 2, comprenant en outre, tout en exposant initialement le substrat (10) au flux de vapeur, le déplacement du substrat pour modifier la direction de croissance des colonnes.

4. Procédé selon la revendication 3, dans lequel le déplacement du substrat (10) pour modifier la direction de croissance inclut la rotation du substrat autour d'une direction normale à la surface du substrat pour établir une croissance hélicoïdale du film mince.

5. Procédé selon la revendication 4, dans lequel le substrat (10) est mu en rotation autour de l'axe normal pendant la seconde période de dépôt.

6. Procédé selon la revendication 1, comprenant en outre la formation de la couche de couverture (74) sur le film mince en colonnes en déposant du matériau, après formation du film mince en colonnes (70) dans des conditions de grande longueur de diffusion.

7. Procédé selon la revendication 6, dans lequel les conditions de grande longueur de diffusion sont générées par chauffage de la surface du substrat (10).

8. Microstructure de film mince, comprenant :
un substrat (10) ;
du matériau déposé en phase vapeur s'étendant en colonnes distinctes (70) depuis le substrat pour former un film mince en colonnes, poreux ; et
**caractérisé en ce que**
les colonnes distinctes se terminent à l'écart du substrat dans une région de matériau formant une couverture dense (74) pour les colonnes.

9. Microstructure de film mince selon la revendication 8, dans laquelle les colonnes (70) sont faites d'un matériau transparent au rayonnement électromagnétique.

10. Microstructure de film mince selon la revendication 8, dans laquelle la couverture (74) et le substrat (10) sont connectés chacun, respectivement, à une première et une seconde électrodes (78).

11. Microstructure de film mince selon la revendication 10, dans laquelle chaque électrode (78) est une plaque s'étendant d'un côté à l'autre de l'un, respectif, de la couverture (74) et du substrat (10).

12. Microstructure de film mince selon la revendication 10, dans laquelle la première et la seconde électrodes (78) sont connectées à une portion de la microstructure de film mince et un capteur d'ondes acoustiques est fixé à la microstructure de film mince à l'écart des électrodes pour permettre la propagation d'ondes acoustiques au travers de la microstructure de film mince depuis les électrodes jusqu'au capteur d'ondes acoustiques.

13. Microstructure de film mince selon la revendication 8, dans laquelle les colonnes (70) sont des colonnes hélicoïdales.
